# EUROPEAN PATENT SPECIFICATION

(11) **EP 3 418 759 B1**
(45) Date of publication and mention of the grant of the patent: **19.02.2020**
(21) Application number: 17305787.8
(22) Date of filing: 23.06.2017
(51) Int. Cl.: G01R 33/09, G01R 33/07

(54) **MAGNETIC HYBRID AMR/PHR BASED SENSING DEVICE AND METHOD FOR MEASURING A LOCAL MAGNETIC FIELD**
MAGNETISCHE HYBRIDE AMR/PHR-BASIERTE MESSVORRICHTUNG UND VERFAHREN ZUR MESSUNG EINES LOKALEN MAGNETFELDES
DISPOSITIF DE DÉTECTION BASÉ SUR AMR/PHR HYBRIDE MAGNÉTIQUE ET PROCÉDÉ DE MESURE D'UN CHAMP MAGNÉTIQUE LOCAL

(43) Date of publication of application: 26.12.2018
(73) Proprietor: UNIVERSITE DE MONTPELLIER, 34090 Montpellier (FR); CENTRE NATIONAL DE LA RECHERCHE SCIENTIFIQUE, 75016 Paris (FR); Daegu Gyeongbuk Institute of Science and Technology, Daegu 711-873 (KR); Ecole Nationale Supérieure de Chimie de Montpellier, 34296 Montpellier (FR)
(72) Inventor: TRAN, Quang-Hung, 34090 MONTPELLIER (FR); TERKI, Férial, 34270 LE TRIADOU (FR); KAMARA, Souleymane, 34090 MONTPELLIER (FR); FELIX, Gautier, 34090 MONTPELLIER (FR); BOUSSEKSOU, Azzedine, 31100 TOULOUSE (FR); KIM, M. CheolGi, 711-873 DAEGU (KR)
(74) Representative: Tanguy, Yannick

(56) References cited:
- US-A1- 2011 175 605
- US-A1- 2015 168 507
- SUNJONG OH ET AL: "Hybrid AMR/PHR ring sensor", SOLID STATE COMMUNICATIONS, PERGAMON, GB, vol. 151, no. 18, 1 September 2011 (2011-09-01), pages 1248-1251, XP028251303, ISSN: 0038-1098, DOI: 10.1016/J.SSC.2011.05.049 [retrieved on 2011-06-12]
- SINHA BRAJALAL ET AL: "Planar Hall resistance ring sensor based on NiFe/Cu/IrMn trilayer structure", JOURNAL OF APPLIED PHYSICS, AMERICAN INSTITUTE OF PHYSICS, US, vol. 113, no. 6, 14 February 2013 (2013-02-14), pages 63903-63903, XP012169936, ISSN: 0021-8979, DOI: 10.1063/1.4790139 [retrieved on 2013-02-08]

## Description

### TECHNICAL FIELD OF THE INVENTION

The present invention concerns a magnetic measurement device and a system based on an ultrasensitive Planar Hall magneto-resistive sensor for measuring locally a time varying magnetic free field generated remotely by one or several magnetic source(s) or for measuring tiny quantities of magnetic particles deposited closely to the sensor. The invention also relates to a method using the magnetic measurement device and system according to the invention for measuring locally an alternative magnetic free field or for measuring locally a time varying magnetic free field generated remotely by one or several magnetic source(s) or for measuring tiny quantities of magnetic particles deposited closely to the sensor.

### BACKGROUND OF THE INVENTION

Various detection methods with magneto-resistive (MR) sensors have been proposed to detect local magnitude and/or variation of a magnetic field generated remotely or closely by one or several magnetic source(s) as for example magnetic micro- nanobeads. These methods use different types of MR sensors, such as semiconductor Hall sensor, anisotropic magnetoresistive (AMR), giant magnetoresistive (GMR), tunneling magnetoresistive (TMR) and giant magneto-impedance (GMI) sensors. These sensors are able to detect small quantities of magnetic particles and/or concentrations of these magnetic particles and described in several papers.

As an alternative to the MR sensors described here above, the use of Planar Hall Magnetoresistive (PHR) sensors has been also proposed in order to detect lower quantities of magnetic particles. Such sensors are described in the document US 2011/175605 A1, the document from Sunjoh Oh et al., entitled "Hybrid AMR/PHR ring sensor", Solid State communications, Pergamon, GB, 1 September, 2011, pages 1248-1251, the document from Sinha Brajahal et al. entitled "Planar Hall resistance ring sensor based on NiFe/Cu/IrMn trilayer structure", Institute of applied physics, American Institute of physics, US, vol. 113, n° 6, 14 February 2013, pages 63903(1)-63903(5) and the patent WO 2014/009516 A1. The Planar Hall Magnetoresistive (PHR) sensors are Anisotropic Magneto Resistance (AMR) coupled with planar Hall effect (PHE) sensors that present a linear dependence as a function of small external field, a very high sensitivity and a high signal-to-noise ratio. These sensors are a growing center of interest in the domain of local magnetic field detection of micro- nanobeads and particularly in the field of magnetic phase transition of bi-stable nano-particles.

However the Hall Magnetoresistive sensors as described in the cited patents still need a relatively high power external biasing field, thus precluding most low power portable battery powered applications. A first technical problem is to propose a portable magnetic hybrid AMR/PHR sensing device for detecting local magnitude and/or variation of a magnetic field generated remotely or closely by one or several magnetic source(s) wherein the power consumption is decreased while keeping a high sensitivity. A second technical problem is to propose a portable magnetic hybrid AMR/PHR sensing device for detecting local magnitude and/or variation of a magnetic field generated remotely or closely by one or several magnetic source(s) wherein the power consumption is decreased while keeping a high sensitivity and operating at low temperature ranging from 4°K to 400°K. A third technical problem is to propose a method for detecting local magnitude and/or variation of a magnetic field generated remotely or closely by one or several magnetic source(s) that uses a portable magnetic hybrid AMR/PHR sensing device with low power consumption while keeping a high measurement sensitivity.

### SUMMARY OF THE INVENTION

The invention aims at solving the first, second and third technical problems. To this end, the invention relates to a magnetic hybrid AMR/PHR based sensing device for detecting local magnitude and/or variation of a magnetic field generated remotely or closely by one or several magnetic source(s), and comprising a magnetic field receiver, as a first component, having a structure of a magnetic hybrid AMR/PHR sensor and that includes a magnetoresistive first track with a closed loop shape or a cross junction shape; a first pair of current terminals formed with a first current terminal and a second current terminal, facing each other, contacting with the magnetoresistive first track and forming a first easy axis; a first pair of voltage terminals formed with a first voltage terminal and a second voltage terminal, facing each other, contacting with the magnetoresistive first track and forming a first hard axis, orthogonal to the first easy axis. The magnetic hybrid AMR/PHR based sensing device is characterized in that it comprises a first magnetic field transmitter as a second component, configured for being excited by a DC and/or AC supplied bias current or by an external magnetic field to be measured and that includes: .- a magnetoresistive or low resistive second track with a closed loop shape or a cross junction shape,
.- a second pair of current terminals formed with a third current terminal and a fourth current terminal, facing each other, contacting with the second track and forming a second easy axis,
.- a second pair of voltage terminals formed with a third voltage terminal and a fourth voltage terminal, facing each other, contacting with the second track and forming a second hard axis, orthogonal to the second easy axis.

The magnetic hybrid AMR/PHR based sensing device is also characterized in that the magnetic field receiver and the magnetic field transmitter are superimposed, secured to and separated by a first insulating spacer configured to align respectively the first easy axis and the first hard axis to the second easy axis and the second hard axis, then rotate the said second axis from said first axis at a predetermines fixed offset angle *α*, and to maintain this axis arrangement as well as a fixed separation distance e₁₂ between the first track and the second track in a range from few micrometers to few nanometers.

According to further aspects of the invention which are advantageous but not compulsory, the magnetic measurement system might incorporate one or several of the following features, taken in any technically admissible combination:
.- the first spacer is a rigid structure made of a rigid insulating material having pillars and beams and/ or ribs, having voids filled by an insulating gas or vacuum; or a bulky homogeneous layer made of a rigid insulating material; or a bully layer made of a rigid insulating material and pierced with at least one longitudinal hole(s), directed along a direction included in the extension plane of the layer, to drive magnetic particle(s) and without lateral opening; or a bulky layer made of a rigid insulating material and pierced with at least one longitudinal hole(s), directed along a direction included in the extension plane of the layer, to drive magnetic particle(s), the longitudinal hole(s) having lateral(s) opening connected to secondary longitudinal hole(s) to provide a control access for controlling a magnetic state of the particle(s); or a bulky layer made of a rigid insulating material and pieced perpendicularly to the layer plane with at least one longitudinal hole(s), when the second track of the first transmitter has a central opening;
.- the rigid insulating material of the first spacer is comprised among the dioxide of silicon SiO₂, and/or the thickness e₁₂ of the insulating layer of the first spacer is ranging from 1 µm to 5 µm, or from 600 nm to 1 µm, or from 200 nm to 600 nm, or from 50 nm to 200 nm, or from 10 nm to 50 nm, or from 1 nm to 10 nm;
.- the shape of the track of the magnetic field receiver and the shape of the track of the first magnetic field transmitter are shapes comprised in the set of the closed loop shapes among the shapes of a ring junction, a multi-ring junction, an oval junction, a multi-oval junction, a diamond junction, a multi-diamond junction, a square junction, a multi-square junction, a rectangular junction, a multi-rectangular junction, and the shape of a cross junction;

.- the material of the first track is a magneto-resistive material among the bi-layer structure material, in particular Ta/NiFe/IrMn/Ta, a tri-layer structure material including a ferromagnetic film, a metal and an anti-ferromagnetic film, in particular Ta/NiFe/Cu/IrMn/Ta, and a spin-valve structure material, in particular Ta/NiFe/Cu/NiFe/IrMn/Ta; and the material of the second track is a magneto-resistive material among a bi-layer structure material, in particular Ta/NiFe/IrMn/Ta, a tri-layer structure material including a ferromagnetic film, a metal and an anti-ferromagnetic film, in particular Ta/NiFe/Cu/IrMn/Ta, and a spin-valve structure material, in particular Ta/NiFe/Cu/NiFe/IrMn/Ta, or is a low resistive material among gold, copper and silver metals;
.- the offset angle a formed between the first easy axis of the magnetic field receiver and the second easy axis of the first field transmitter is selected in the range [0 degree, 90 degrees] so that the sensitivity of the sensing device is maximal, and preferably is comprised within the range [15 degrees, 25 degrees];
.- the accuracy of the alignment of the axis before their rotation is below 10 nm, and the accuracy of the set a angle is below 1.0 degree, preferably below 0.02 degree;
.- the magnetic field receiver and the first magnetic field transmitter are identical, or the magnetic field receiver and the first magnetic field transmitter mutually differ by the shape of their electromagnetic track, and/or the material of their electromagnetic track;
.- the magnet hybrid AMR/PHR based sensing device comprises further a second magnetic field transmitter as a third component, configured for being excited by a DC and/or AC supplied bias current or by an external magnetic field to be measured and that includes: a magnetoresistive or low resistive third track with a closed loop shape or a cross junction shape, a third pair of current terminals formed with a fifth current terminal and a sixth current terminal, facing each other, contacting with the third track and forming a third easy axis, a third pair of voltage terminals formed with a fifth voltage terminal and a sixth voltage terminal, facing each other, contacting with the third track and forming a third hard axis, orthogonal to the third easy axis; and the first magnetic field transmitter and the second magnetic field transmitter are identical; and the first magnetic field transmitter, the magnetic field receiver and the second magnetic field transmitter are superimposed and mutually secured through the first spacer and a second spacer so that the field magnetic receiver is sandwiched between the first field magnetic transmitter and the second field magnetic transmitter;
.- the second insulating spacer is configured to secure the second magnetic field transmitter to the magnetic field receiver on the opposite side of the first insulating spacer, once an alignment of the respective first easy axis and the first hard axis to the respective third easy axis and the third hard axis, followed by a rotation of the said third axis from the said first axis at the predetermined fixed offset angle α, and to maintain this axis arrangement as well as a fixed separation distance e₁₃ between the first track and the third track equal to the fixed separation distance e₁₂ between the first track and the second track; and the second spacer is a bulky homogeneous layer made of the rigid insulating material as the insulating material of the first spacer;
.- the magnetic hybrid MR/PHR based sensing device comprises further: either a single second track current source for supplying a DC and/or AC current to the second track of the first magnetic field transmitter when the magnetic sensing device comprises the magnetic field receiver and the first magnetic field transmitter as a single magnetic field transmitter; or a second track current source and a third track current source for supplying a DC and/or AC current respectively to the second track of the first magnetic field transmitter and to the third track of the second magnetic field transmitter when the magnetic sensing device comprises the magnetic field receiver and two first and second magnetic field transmitter to operate in a differential mode, the second track current source and the third track current source being configured and connected to the second track of the first magnetic field transmitter and to the third track of the second magnetic field transmitter in order to generate two magnetic fields, symmetric to the plane of the magnetic field receiver and polarized with opposite direction;
.- the magnetic hybrid AMR/PHR based sensing device comprises further an amplifier circuit connected to the first and second voltage terminals for amplifying a measurement signal and/or cancel a offset voltage from the said measurement signal.

The invention also relates to a magnetic measurement method for measuring local magnitude and/or variation of a magnetic field generated remotely or closely by one or several magnetic source(s) according to a first embodiment. The magnetic measuring method comprises the steps of :
- providing a magnetic hybrid AMR/PHR based sensing device comprising a magnetic field receiver and a first magnetic field transmitter as defined here above;
- measuring a differential voltage V_{MR} between the voltage terminals of the first pair by using a voltage measurement device connected between the first and second voltage terminals, while keeping disconnected the first pair of current terminals of the magnetic field receiver, the first pair of voltage terminals of the magnetic field receiver, and the second pair of current terminals of the first magnetic field transmitter so that the impedance between the first pair of current terminals, the impedance between the first pair of voltage terminals, the impedance between the second pair of current terminals are representative of an open circuit;
- determining a local magnitude and/or variation of a time varying magnetic field generated remotely or closely by one or several magnetic source(s) on the basis of the measured differential voltage.

According to a second embodiment, the invention also relates to a magnetic measurement method for measuring local amplitude and/or variation of a magnetic field generated by one or several magnetic source(s). The magnetic measuring method comprises the steps of :
- providing a magnetic hybrid AMR/PHR based sensing device comprising a magnetic field receiver and a first magnetic field transmitter as defined here above,
- injecting a bias DC and/or AC current in the second magnetic track of the first magnetic field transmitter by using an electrical bias current source connected between the third and fourth current terminals of the first magnetic field transmitter, and
- driving a set of one or several magnetic particles sensitive to a magnetic field in the vicinity or in contact of an active area of the magnetic receiver located under the magnetic track of the first magnetic field transmitter; then
- measuring a differential voltage V_{MR} between the first and second voltage terminals of the magnetic field receiver by using a voltage measurement device connected between the first and second voltage terminals, while keeping disconnected the first pair of current terminals of the magnetic field receiver and the second pair of voltage terminals of the first magnetic field transmitter so that the impedance between the first pair of current terminals, and the impedance between the second pair of voltage terminals are representative of an open circuit;
- determining a local magnitude and/or variation of a time varying magnetic field generated closely by the magnetic particles on the basis of the measured differential voltage.

According to a third embodiment, the invention also relates to a magnetic measurement method for measuring local amplitude and/or variation of a magnetic field generated by one or several magnetic source(s). The magnetic measuring method comprising the steps of:
- providing a magnetic hybrid AMR/PHR based sensing device comprising a magnetic field receiver, a first magnetic field transmitter and a second magnetic field transmitter as defined here above,
- injecting a bias DC and/or AC current in the second magnetic track of the first magnetic field transmitter and the third magnetic track of the second magnetic field transmitter by using an electrical bias current source connected between the third and fourth current terminals of the first magnetic field transmitter and between the fifth and the sixth current terminals of the second magnetic field transmitter so that the excitation magnetic fields generated by the first magnetic field transmitter and the second magnetic field transmitter are polarized on opposite direction, and
- driving a set of one or several magnetic particles sensitive to a magnetic field in the vicinity or in contact of an active area of the magnetic receiver located under the magnetic track of the first magnetic field transmitter; then
- measuring a differential voltage V_{MR} between the first and second voltage terminals of the magnetic field receiver by using a voltage measurement device connected between the first and second voltage terminals, while keeping disconnected the first pair of current terminals of the magnetic field receiver and the second pair of voltage terminals of the first magnetic field transmitter so that the impedance between the first pair of current terminals, and the impedance between the second pair of voltage terminals are representative of an open circuit;
- determining a local magnitude and/or variation of a time varying magnetic field generated closely by the magnetic particles on the basis of the measured differential voltage.

### BRIEF DESCRIPTION OF THE DRAWINGS

The invention will be better understood on the basis of the following description which is given in correspondence with the annexed figures and as an illustrative example, without restricting the object of the invention. In the annexed figures:

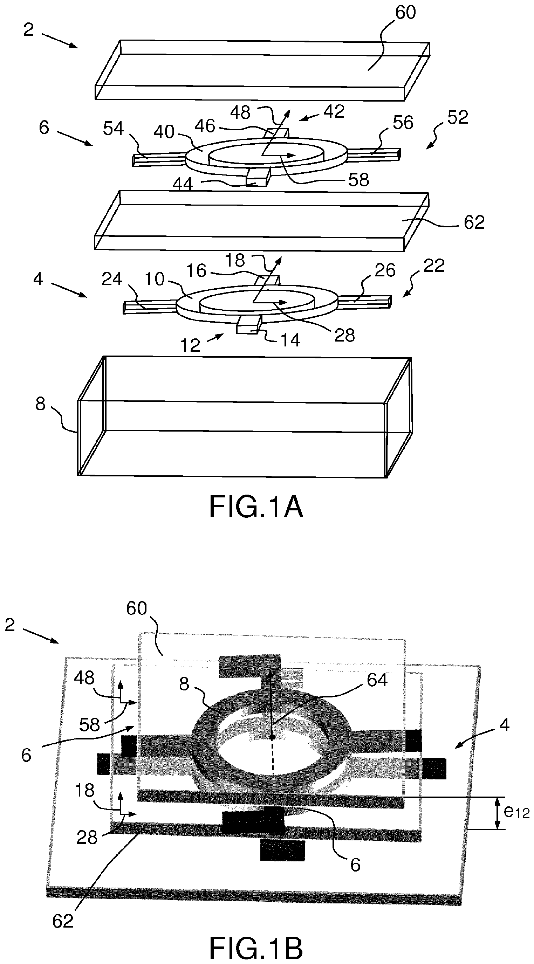

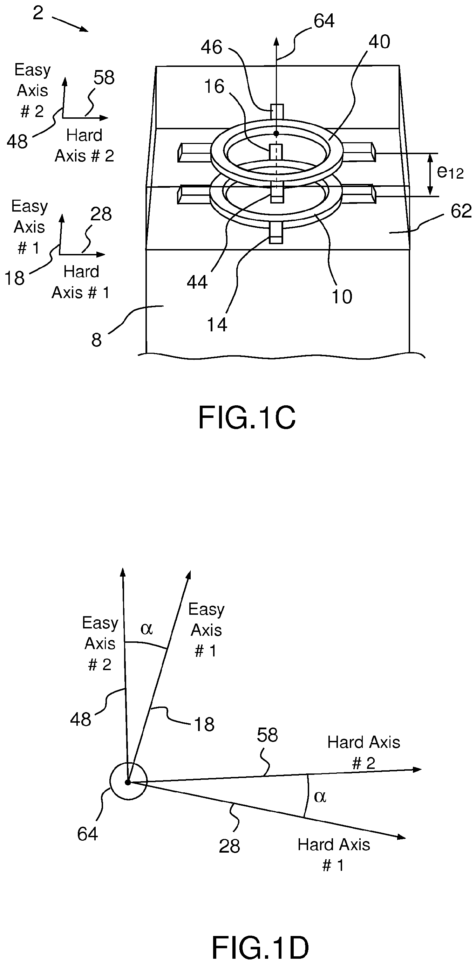

- Figures 1A, 1B, 1C and 1D are respectively an exploded view and an integrated view of a magnetic hybrid AMR/PHR based sensing device according to a first embodiment of the invention wherein a magnetic field receiver and a magnetic field transmitter are used, a simplified view of the same sensing device highlighting the main components of the sensing, and an exemplary illustration of an offset angle α between the magnetic field receiver and the magnetic field transmitter;

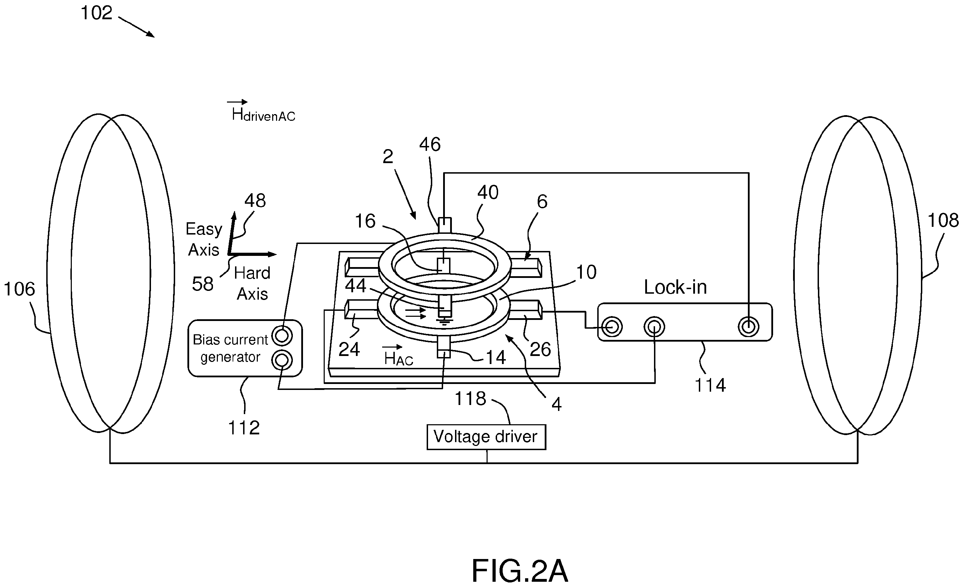

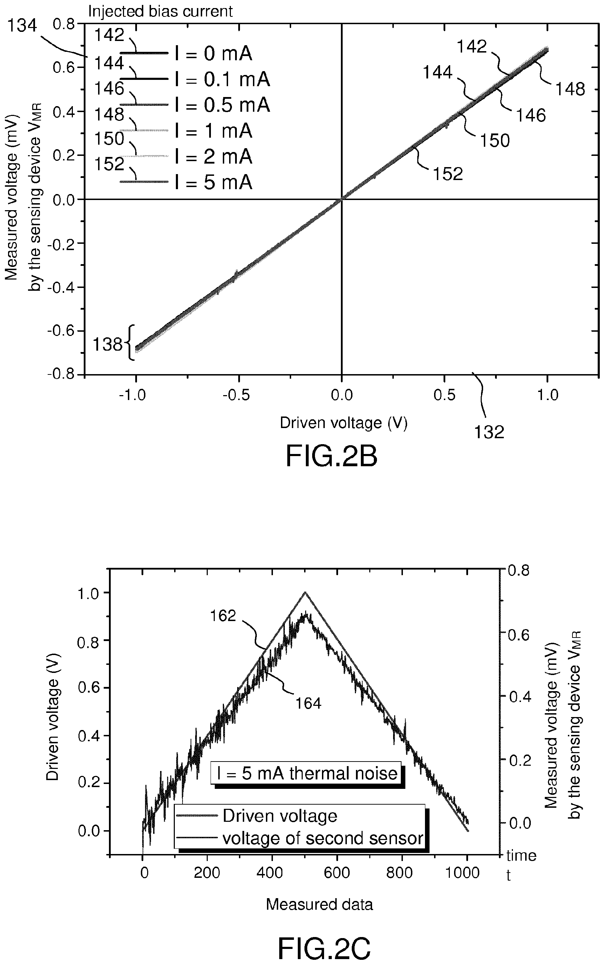

- Figures 2A, 2B, and 2C are respectively a first view illustrating an experimental set up testing the behavior of the magnetic hybrid AMR/PHR based sensing device according to the first embodiment of Figures 1A-1B, a second view of the evolution of the detected local magnetic field by the magnetic field receiver versus a known driven AC field while applying different bias currents onto the first and second current terminals of the magnetic field receiver, and a third view of the co-evolution versus time of the measured voltage V_{MR} by the sensing device and a driven voltage applied to the Helmholtz coils following a time varying triangular waveform ;

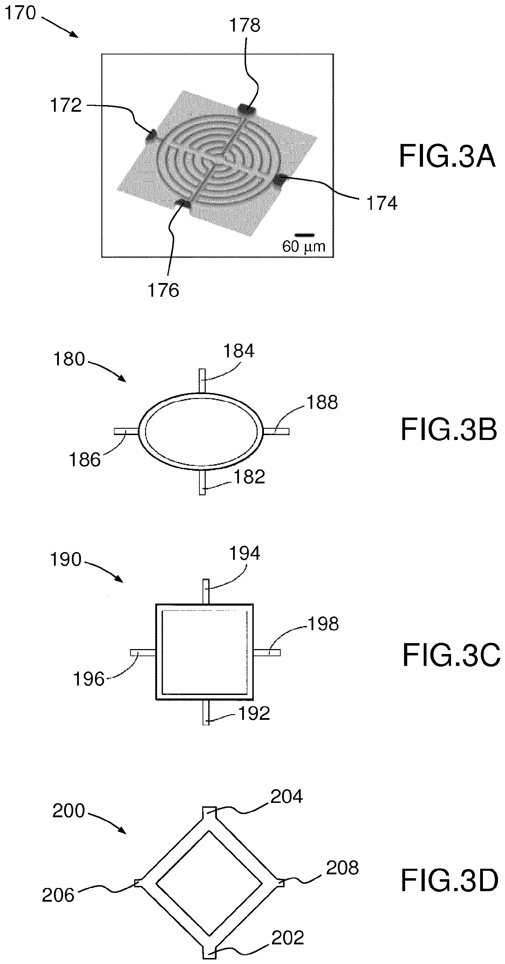

- Figures 3A to 3F are views illustrating variant shapes of the electromagnetic track of the magnetic field receiver as shown in Figures 1A-1B, respectively a multi-ring shape, an oval shape, a square shape, a diamond shape, a multi-diamond shape, and a cross junction shape;

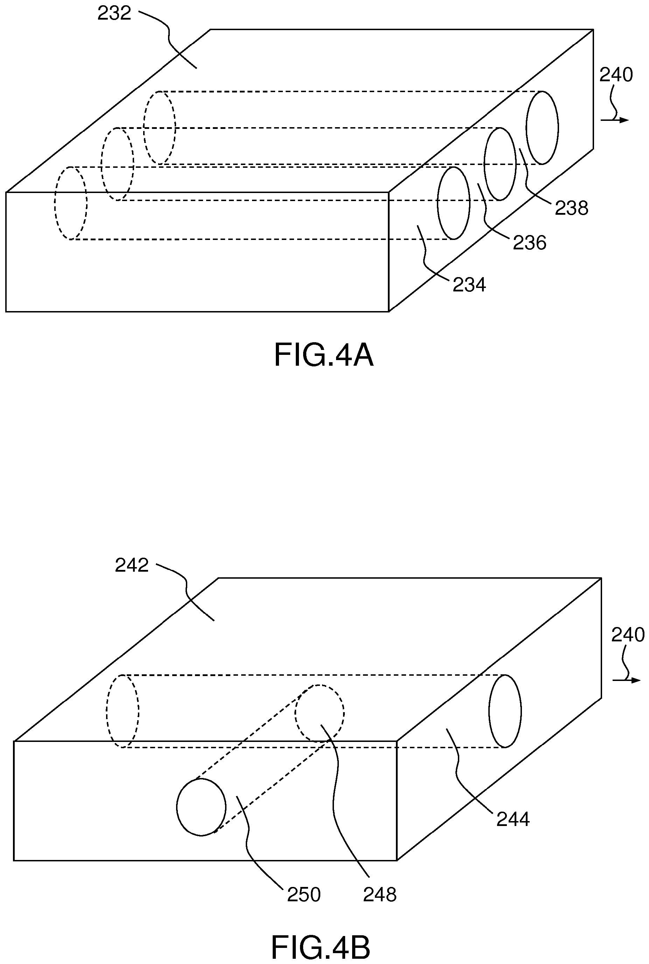

- Figures 4A to 4C are views illustrating exemplary variants of the first spacer as shown, respectively a layer with pierced longitudinal holes to drive magnetic particles, a layer with a single pierced longitudinal hole to drive magnetic particles and a lateral hole pierced to access the single hole and permit a control of the magnetic state of the particle(s), and a layer with a perpendicular access hole extending perpendicularly from a central void area of a first magnetic field transmitter;
- Figured 5A and 5B are respectively a view of a magnetic measurement system according to a first system embodiment using a sensing device according to the first sensing device embodiment of Figure 1B and configured to implement a magnetic measurement method according to a first method embodiment, and a flow chart magnetic measurement method according to the first method embodiment ;
- Figured 6A and 6B are respectively a view of a magnetic measurement system according to a second system embodiment using a sensing device according to the first sensing device embodiment of the invention with a first spacer as shown in Figures 4A-4C and configured to implement a magnetic measurement method according to a second method embodiment, and a flow chart magnetic measurement method according to the second method embodiment;
- Figures 7A and 7B are respectively an exploded view and an integrated view of a magnetic hybrid AMR/PHR based sensing device according to a second sensing device embodiment of the invention where a magnetic field receiver and two magnetic field transmitters are used;
- Figure 8 is schematic view illustration the differential mode operation of the sensing device of Figures 7A and 7B;
- Figures 9A and 9B are respectively a view of a magnetic measurement system according to a third system embodiment using a sensing device according to the second sensing device embodiment of Figure 7B and configured to implement a magnetic measurement method according to a third method embodiment, and a flow chart magnetic measurement method according to the third method embodiment.

### DETAILED DESCRIPTION OF SOME EMBODIMENTS

According to Figures 1A, 1B and 1C and a first device embodiment of the invention, a magnetic hybrid AMR/PHR based sensing device 2 is configured for detecting local magnitude and/or variation of a magnetic field generated remotely or closely by one or several magnetic source(s).

The magnetic sensing device 2 comprises a magnetic field receiver 4 as a first component and a first magnetic field transmitter 6 as a second component, and a substrate 8 serving as support of the set formed by the magnetic field receiver 4 and the first magnetic field transmitter 6.

The magnetic field receiver 4 has a structure of a magnetic hybrid AMR/PHR sensor and includes:
- a magneto-resistive first track 10 with a closed loop shape or a cross junction shape, here a magneto-resistive single ring,
- a first pair 12 of current terminals 14, 16, formed with a first current terminal 14 and a second current terminal 16, facing each other, contacting with the magneto-resistive first track 8 and forming a first easy axis 18,
- a first pair 22 of voltage terminals 24, 26, formed with a first voltage terminal 24 and a second voltage terminal 26, facing each other, contacting with the magneto-resistive first track 10 and forming a first hard axis 28, orthogonal to the first easy axis 18.

The first magnetic field transmitter 6 is configured for being excited by a DC and/or AC current supplied by a bias current generator or by a time varying external magnetic field to be measured, and includes:
- a magneto-resistive or low resistive second track 40 with a closed loop shape or a cross junction shape,
- a second pair 42 of current terminals 44, 46, formed with a third current terminal 44 and a fourth current terminal 46, facing each other, contacting with the second track 40 and forming a second easy axis 48,
- a second pair 52 of voltage terminals 54, 56, formed with a third voltage terminal 54 and a fourth voltage terminal 56, facing each other, contacting with the second track 40 and forming a second hard axis 58, orthogonal to the second easy axis 48.

The second track 40 of the first magnetic field transmitter is covered by a passivation layer 60.

The magnetic field receiver 4 and the first magnetic field transmitter 6 are superimposed, secured to and separated by a first insulating spacer 62 configured to align respectively the first easy axis 18 and the first hard axis 28 to the second easy axis 48 and the second hard axis 58, then rotate the said second axis 48, 58, from the said first axis 18, 28 about a common perpendicular axis 64 at a predetermined fixed offset angle α, and to maintain this axis arrangement as well as a fixed separation distance e₁₂ between the first track 6 and the second track 8 in a range from few micrometers to few nanometers.

Here, in the Figures 1A and 1B the value of the predetermined offset angle α is assumed equal to zero.

More generally, the offset angle α formed between the firs easy axis 18 and the second easy axis, or equivalently between the first hard axis 28 and the second hard axis 58 is selected in the range [0 degree, 90 degree] so that the sensitivity of the magnetic sensor is maximal, and preferably is comprised within the range [15 degree, 25 degree] as shown in the Figure 1D.

According to the Figure 1D, the offset angle α that optimizes the magnetic sensing device 2 is assumed to be equal 20 degrees.

According to Figure 2A an experimental system 102 for testing the behavior of the magnetic hybrid AMR/PHR based sensing device 2 according to the first embodiment of Figures 1A to 1D comprises a sample unit to be tested 2 as defined in Figures 1A to 1D, a pair of Helmholtz coils 106, 108 configured to generate a magnetic driven field H_{AC} oscillating at a predetermined frequency ω applied in the vicinity of the sensing device 2 along the second hard axis of the first magnetic field transmitter, a bias current generator 112 to polarize the magnetic field receiver, and a measurement unit 114 connected to the voltage terminals 24, 26 of the AMR/PHR magnetic field receiver 4 and locked to a current signal taken at the current terminals 44, 46 of the track 40 of the first magnetic field transmitter 6.

The two Helmholtz coils 16, 108 share and are connected to a driven current or voltage generator 118 configured to inject a DC+AC or AC driven current in the Helmholtz coils 16, 108, that can be translated into a driven voltage expressed in volts and ranging from -1.0 V (Volt) to +1.0 V (Volt) on a first abscissa axis in the Figure 2B.

Here, the magnetic field receiver and the first magnetic field transmitter are separated by a passivation layer forming the first spacer, the thickness thereof is comprised within 100nm to 1µm and the diameter of the first magneto-resistive ring track is here equal to 600 µm.

According to the Figure 2B, the evolution of the magneto-resistive voltage V_{MR}, measured by the sensing device 2 between the voltage terminals 24, 26 of the track 10 of the magnetic field receiver 4 and expressed in mV (milliVolt) on a second ordinate axis 134, versus the driven voltage, is plot in a set 138 of curves 142, 144, 146, 148, 150, 152 corresponding to a DC bias current injected through the current terminals 14, 16 of the AMR/PHR track 10 of the magnetic receiver 4 respectively equal to 0 mA, 0.1 mA, 0.5 mA, 1 mA, 2 mA and 5 mA.

As shown in the Figure 2B, the measurements of the sensing voltage V_{MR} achieved by using the test configuration of the Figure 2A, indicate that the curves 142, 144, 146, 148, 150, 152 are almost the same and are therefore independent from the intensity of the bias current injected in the AMR/PHR track 1 of magnetic field receiver 4, the magnetic field receiver forming an actual sensor of a local magnetic field along the first hard axis and the first magnetic field transmitter forming a kind of local magnetic field lens.

Regardless of the intensity of an injected bias current, an alternative AC magnetic field H_{AC} at a given frequency ω induces an alternative current with the same frequency ω for the receiver 4 of the sensing device 2. The amplitude of the induced current is proportional to the magnitude of the alternative magnetic field H_{AC}. When injecting a bias current into the track 10 of the receiver 4, no increment is observed in the detected voltage signal V_{MR} with the magnitude of the injected bias current but only an increment of the noise through the thermal noise signal component as shown in the Figure 2C.

According to Figure 2C, a direct DC bias current is injected into the magneto-resistive first track 10 of the receiver 4 through the first and second current terminals and a driven voltage is applied to the Helmholtz coils following a time varying triangular waveform 162. The corresponding evolution of the measured voltage V_{MR} versus time t is illustrated by a curve 164.

Accordingly, the sensing device 2 according the invention is configured to a avoid any injection of a direct DC bias current through the first and second current terminals by implementing an open circuit between the said first and second current terminals through an insulating material.

In such a test configuration it is thus shown that the no bias current need to be injected, which means that the AMR/PHR sensor forming the magnetic field receiver 4 does not need a power voltage supply to detect a local magnetic field. Accordingly, the magnetic field receiver can detect the induced collimated field generated by the track second track of the first magnetic field transmitter also without any supply power.

Generally, the shape of the magnetic field receiver and the shape of the first magnetic field transmitter are shapes comprised in the set of the closed loop shapes among the shapes of a ring junction, a multi-ring junction, an oval junction, a multi-oval junction, a diamond junction, a multi-diamond junction, a square junction, a multi-square junction, a rectangular junction, a multi-rectangular junction, and the shape of a cross junction.

As example, a multi-ring junction 170 is illustrated in Figure 3A with a pair of current terminals 172, 174 and a pair of voltage terminals 176, 178.

As example, an oval junction 180 is illustrated in Figure 3B with a pair of current terminals 182, 184 and a pair of voltage terminals 186, 188.

As example, a square junction 190 is illustrated in Figure 3C with a pair of current terminals 192, 194 and a pair of voltage terminals 196, 198.

As example, a diamond junction 200 is illustrated in Figure 3D with a pair of current terminals 202, 204 and a pair of voltage terminals 206, 208.

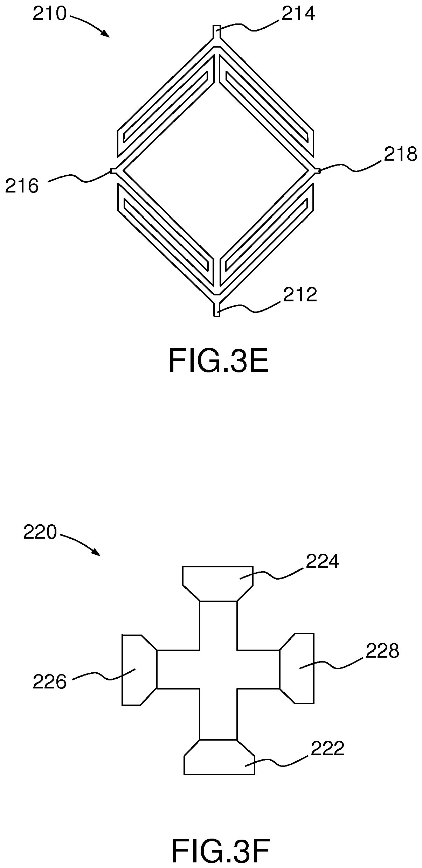

As example, a multi-diamond junction 210 is illustrated in Figure 3E with a pair of current terminals 212, 214 and a pair of voltage terminals 216, 218.

As example, a cross junction 220 is illustrated in Figure 3F with a pair of current terminals 222, 224 and a pair of voltage terminals 226, 228.

According to the Figures 1A and 1B the first spacer is a bulky homogeneous layer made of a rigid insulating material.

As a first variant, the spacer is a rigid structure made of a rigid insulating material having pillars and beams and/ or ribs, having voids filled by an insulating gas or vacuum.

According to the Figure 4A and as a second variant, the first spacer is a bulky layer 232 made of a rigid insulating material and pierced with at least one longitudinal hole(s), here three longitudinal holes 234, 236, 238, directed along a direction 240 included in the extension plane of the layer 232, to drive magnetic particle(s) and without lateral opening. For example, the direction of the longitudinal holes is chosen so that when the first spacer and the magnetic field receiver are integrated the first hard axis of the magneto-resistive first track and the extension direction of the longitudinal holes are parallel.

According to the Figure 4B and as a third variant, the first spacer is a bulky layer 242 made of a rigid insulating material and pierced with at least one longitudinal hole(s), here a single longitudinal hole 244, directed along a direction 246 included in the extension plane of the layer, to drive magnetic particle(s). The longitudinal hole(s), here the single hole 244, have/has lateral(s) opening, here one lateral opening 248, connected to secondary longitudinal hole(s), here one se secondary longitudinal hole 250 in the Figure 4B, to provide a control access for controlling a magnetic state of the particle(s).

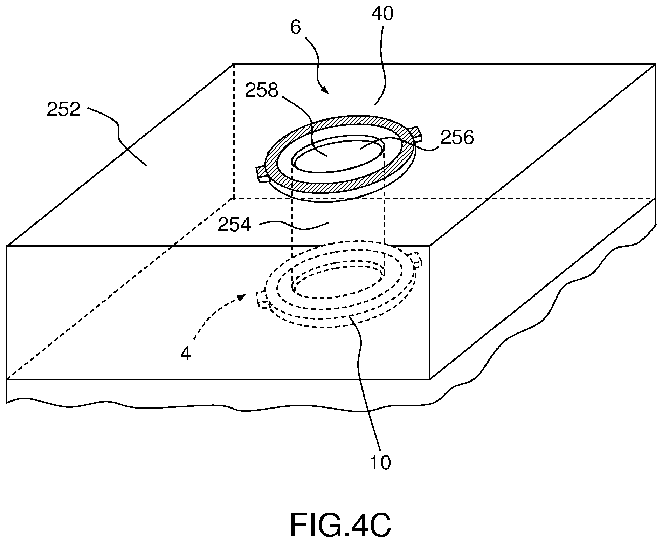

According to the Figure 4C and a fourth variant, the first spacer is a bulky layer 252 made of a rigid insulating material and pierced perpendicularly to the layer plane with at least one longitudinal hole(s), here a single longitudinal hole 254, at a predetermined location 256. The predetermined location 256 is determined so that the longitudinal hole 254 opens at one end to a central opening 258 of the second track 40 of the first magnetic field transmitter 6, when the second track 40 of the first transmitter 6 has such a central opening 258 and when the first spacer and the first magnetic field transmitter are integrated.

According to the Figures 1A-1C and 4A-4C, the rigid insulating material of the first spacer is comprised among the dioxide of silicon SiO₂.

The thickness e₁₂ of the insulating layer of the first spacer is ranging from 1 µm to 5 µm, or from 600 nm to 1 µm, or from 200 nm to 600 nm, or from 50 nm to 200 nm, or from 10 nm to 50 nm, or from 1 nm to 10 nm.

According to the Figures 1A-1C and 4A-4C, the material of the first track is a magneto-resistive material among the bi-layer structure material, in particular Ta/NiFe/IrMn/Ta, a tri-layer structure material including a ferromagnetic film, a metal and an anti-ferromagnetic film, in particular Ta/NiFe/Cu/IrMn/Ta, and a spin-valve structure material, in particular Ta/NiFe/Cu/NiFe/IrMn/Ta; and
the material of the second track is a magneto-resistive material among a bi-layer structure material, in particular Ta/NiFe/IrMn/Ta, a tri-layer structure material including a ferromagnetic film, a metal and an anti-ferromagnetic film, in particular Ta/NiFe/Cu/IrMn/Ta, and a spin-valve structure material, in particular Ta/NiFe/Cu/NiFe/IrMn/Ta, or is a low resistive material among gold, copper and silver metals.

The accuracy of the alignment of the axis before their rotation is below 10 nm and the accuracy of the set α angle is below 1,0 degree, preferably below 0, 02 degree.

Generally, the magnetic field receiver 4 and the first magnetic field transmitter 5 are identical, or the magnetic field receiver 4 and the first magnetic field transmitter 6 mutually differ by the shape of their magnetic track, and/or the material of their electromagnetic track.

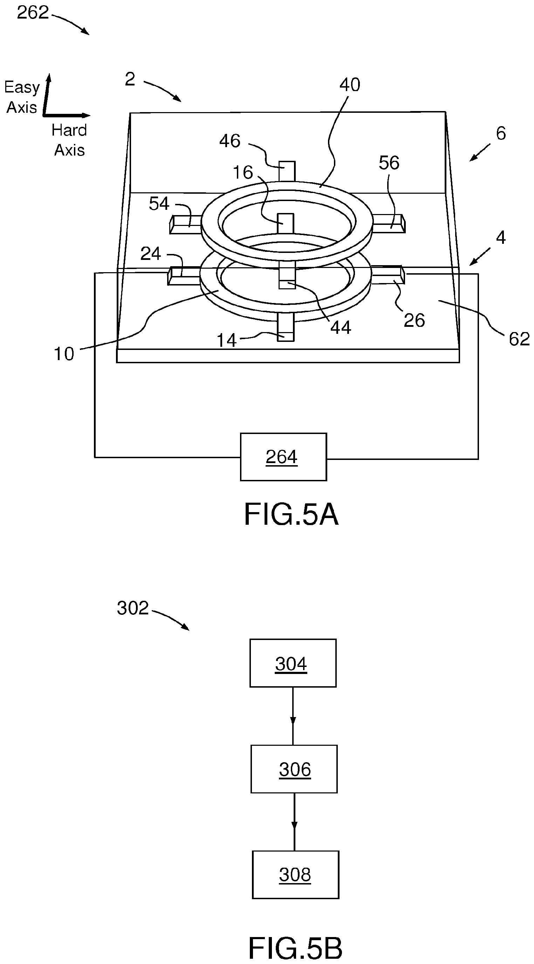

According to Figure 5A and a first embodiment, a magnetic measuring system 262 comprises the magnetic hybrid AMR/PHR based sensing device 2 as described in the Figures 1A-1B, and a voltage measurement device 264 connected between the first and second voltage terminals.

The magnetic measuring system 262 is configured for keeping disconnected the first pair of current terminals 14, 16 of the magnetic field receiver 4, the second pair of current terminals 44, 46 of the first magnetic field transmitter 6, and the second pair of voltage terminals 54, 56 so that the impedance between the first pair of current terminals 14, 16, the impedance between the second pair of current terminals 44, 46, the impedance between the second pair of voltage terminals are representative of open circuits.

The voltage measurement device 264 comprises an amplifier circuit, connected to the first and second voltage terminals, for amplifying a measurement signal and/or cancelling an offset voltage from the said measurement signal.

In a particular embodiment, the amplifier is integrated within the magnetic sensing device 2.

The magnetic measuring system 262 is well suited to measure local magnitude and/or variation of a time varying magnetic field, generated remotely or closely by one or several magnetic source(s) and to implement the magnetic measuring method according to the invention as described in the Figure 5B.

According to Figure 5B and a first method embodiment of the invention, a magnetic measuring method 302 comprises a first set of steps for measuring local magnitude and/or variation of a magnetic field generated remotely or closely by one or several magnetic source(s).

In a first step 304, a magnetic hybrid AMR/PHR based sensing device as described here above in the Figures 1A-1C and 4A-4C, is provided. The sensing device comprises a magnetic field receiver and a first magnetic field transmitter as described here above.

Then in a second step 306, a differential voltage V_{MR} between the voltage terminals of the first pair is measured by a voltage measurement device connected between the first and second voltage terminals, while keeping disconnected the first pair of current terminals of the magnetic field receiver, the first pair of voltage terminals of the magnetic field receiver, and the second pair of current terminals of the first magnetic field transmitter, so that the impedance between the first pair of current terminals, the impedance between the first pair of voltage terminals, the impedance between the second pair of current terminals are representative of open circuits.

Then in a third step 308, a local magnitude and/or variation of a time varying magnetic field, generated remotely or closely by one or several magnetic source(s), is determined on the basis of the measured differential voltage.

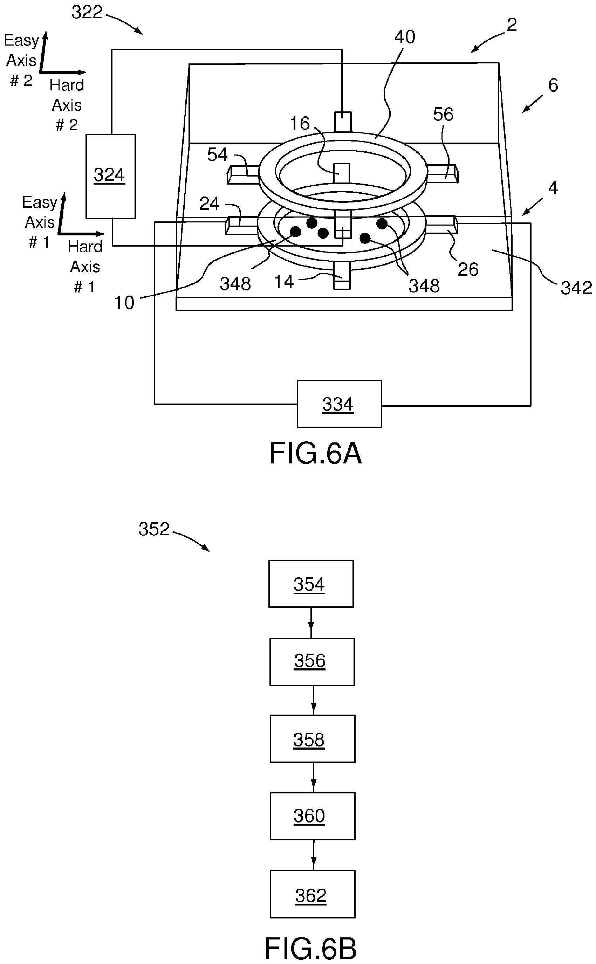

According to Figure 6A and a second system embodiment, a magnetic measuring system 322 according to the invention comprises the magnetic hybrid MR/PHR based sensing device 2 as described in the Figures 1A-1B, one second track current source 324 for supplying a DC and/or AC current to the second track 40 of the first magnetic field transmitter 6 and a voltage measurement device 334, similar to the voltage measurement device 264 of the Figure 5A and connected between the first pair of voltage terminals 24, 26.

The magnetic measuring system 322 is configured for keeping disconnected the first pair of current terminals 14, 16 of the magnetic field receiver 4, the second pair of voltage terminals 54, 56 so that the impedance between the first pair of current terminals 14, 16, the impedance between the second pair of voltage terminals 54, 56 are representative of open circuits.

The voltage measurement device 334 comprises an amplifier circuit, connected to the first and second voltage terminals 24, 26, for amplifying a measurement signal and/or cancelling an offset voltage from the said measurement signal.

In a particular embodiment, the amplifier is integrated within the magnetic sensing device 2.

Moreover, here the first spacer 342 is similar to a spacer among the described spacers of Figure 4A, 4B and 4C. Such a spacer 342 is configured to drive magnetic particles 348 in the vicinity and close to an active area of the magneto-resistive track 10 of the magnetic field receiver 4.

The magnetic measuring system 322 is well suited to measure local magnitude and/or variation of a magnetic field, generated closely by one or several magnetic particles and to implement a magnetic measuring method according to a second method embodiment described in Figure 6B.

The magnetic particles to be detected by the magnetic sensing device according to the invention are comprised in the family of:
.- any switchable molecular nanoparticles in form of AₕBₖ[M(CN)₆]_{I}.mH₂O, where A can be Co, Ni, Fe, etc, B and M can be various transition metals (Fe^{II}, Fe^{III}, Mn", Mn^{III}, Co^{II}, Co^{III}, Ni^{II}, Ni^{III}...);
.- any Hoffman clathrate switchable molecular nanoparticles in form of Fe^{II}(A)[M^{II}(CN)₄].nH₂O, where A is the ligand field (pz, azpy,...) and M^{II} is a metallic ion (Ni, Pd, and Pt);
.- any spin crossover nanoparticles of triazole family: [Fe(hptrz)3]OTs)2.(hptrz=4-heptyl-1,2,4-triazole and OTs=toluenesulfonyl);
.- any paramagnetic or superparamagnetic particles: Fe₂O₃, Fe₃O₄, Fe@Fe₃O₄, CoFe@Fe₃O₄, Ni, ...;
.- any ferromagnetic particles: Fe, CoFe, Ni;
.- any anti-ferromagnetic particles;
.- any particles with multilayer structure Ti/Fe, Cr, NiO, Co₃O₄, a-Fe₂O₃, CuO, MnO,Cr₂O₃ nano-particles;
.- any magnetic bead made of Fe₃O₄ in the polymer or any amorphous (silica, xerogel, aerogel, ...) matrix with the sphere shape and any size ranging from 50 nm to 10 µm.

According to Figure 6B and a second method embodiment of the invention, a magnetic measuring method 352 comprises a second set of steps for measuring local magnitude and/or variation of a magnetic field generated closely by one or several magnetic source(s).

In a first step 354, a magnetic hybrid AMR/PHR based sensing device 2, as described in the Figures 1A-1C and 4A-4C, is provided. The sensing device comprises a magnetic field receiver and a first magnetic field transmitter as described here above as well as a first spacer similar to one of the spacers of Figure 4A to 4C.

Then in a second step 356, a bias DC and/or AC current is injected in the electromagnetic second track 40 of the first magnetic field transmitter 6 by using an electrical bias current source connected between the third and fourth current terminals of the first magnetic field transmitter.

Then in third step 358, a set of one or several magnetic particles sensitive to a magnetic field are driven in the vicinity or in contact of an active area of the magneto-resistive track of the magnetic field receiver, the active area being located under the electromagnetic second track of the first magnetic field transmitter.

Then in a fourth step 360, a differential voltage V_{MR} between the first and second voltage terminals 24, 26 of the magnetic field receiver 4 is measured by a voltage measurement device connected between the first and second voltage terminals, while keeping disconnected the first pair of current terminals 14, 16 of the magnetic field receiver and the second pair of voltage terminals 54, 56 of the first magnetic field transmitter so that the impedance between the first pair of current terminals 14, 16, and the impedance between the second pair of voltage terminals 54, 56 are representative of open circuits.

Then in fifth step 362, a local magnitude and/or variation of a magnetic field generated closely by the magnetic particles is determined on the basis of the measured differential voltage V_{MR}.

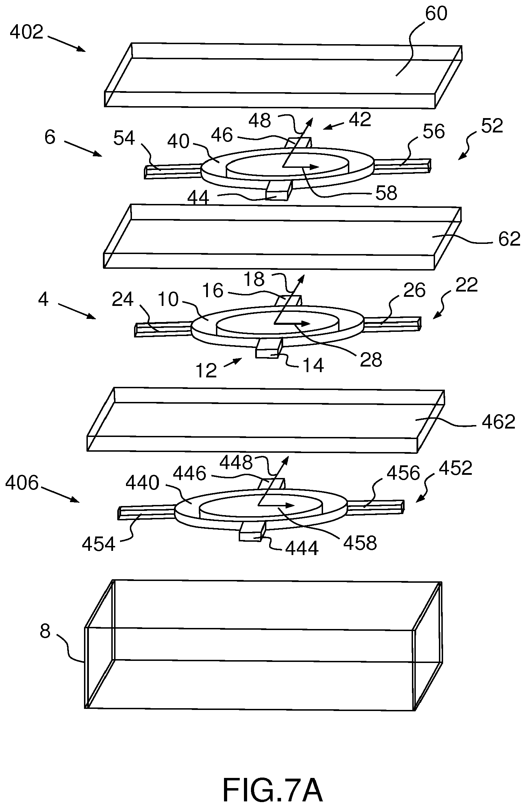

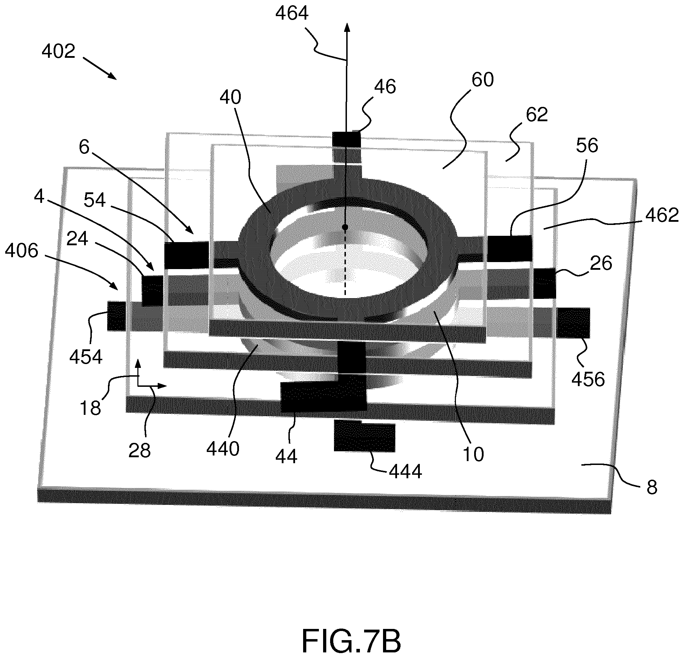

According to Figures 7A and 7B and a second magnetic sensing device embodiment, a magnetic hybrid MR/PHR based sensing device 402 comprises the same following components of the magnetic sensing device 2 of Figures 1A-1B: the magnetic field receiver 4, the first magnetic field transmitter 6, the first spacer 62, the passivation layer 60, and the substrate 8. The magnetic field receiver 4, the first magnetic field transmitter 6 and the first spacer 62 of the magnetic sensing device 402 according the second device embodiment are also arranged in the same way as for the magnetic sensing device 2 of Figures 1A-1B according to the first embodiment.

The magnetic sensing device 402 according to the second embodiment differs from the magnetic sensing device 2 according to the first embodiment in that it comprises further a second magnetic field transmitter 406 as a third component.

The second magnetic field transmitter 406 is configured for being excited by a DC and/or AC supplied bias current or by an external magnetic field to be measured, and includes:
- a magneto-resistive or low resistive third track 440 with a closed loop shape or a cross junction shape,
- a third pair 442 of current terminals 444, 446 formed with a fifth current terminal 444 and a sixth current terminal 446, facing each other, contacting with the third track 440 and forming a third easy axis 448,
- a third pair 452 of voltage terminals 454, 456, formed with a fifth voltage terminal 554 and a sixth voltage terminal 556, facing each other, contacting with the third track 440 and forming a third hard axis 458, orthogonal to the third easy axis 448.

The first magnetic field transmitter 6 and the second magnetic field transmitter 406 are identical.

The first magnetic field transmitter 6, the magnetic field receiver 4 and the second magnetic field transmitter 406 are superimposed and mutually secured through the first spacer 62 and a second spacer 462 so that the field magnetic receiver 4 is sandwiched between the first field magnetic transmitter 6 and the second field magnetic transmitter 106.

The second insulating spacer 462 is configured to secure the second magnetic field transmitter 406 to the magnetic field receiver 4 on the opposite side of the first insulating spacer 62, once performed an alignment of the respective first easy axis 18 and the first hard axis 28 to the respective third easy axis 448 and the third hard axis 458, followed by a rotation of the said third axis 448, 458 from the said first axis 18, 28 about the common perpendicular axis 464 at the same predetermined fixed offset angle α of the Figures 1A-1D, and is configured to maintain this axis arrangement as well as a fixed separation distance e₁₃ between the first track 10 and the third track 440 equal to the fixed separation distance e₁₂ between the first track and the second track.

The second spacer 462 is a bulky homogeneous layer made of the same rigid insulating material as the insulating material of the first spacer 62.

The whole sandwich structure formed by the second magnetic field transmitter 406, the second spacer 462, the magnetic field receiver 4, the first spacer 62, the first magnetic field transmitter and the optional passivation layer, is supported by the substrate 8 through the second magnetic field transmitter 6 and the second spacer 462.

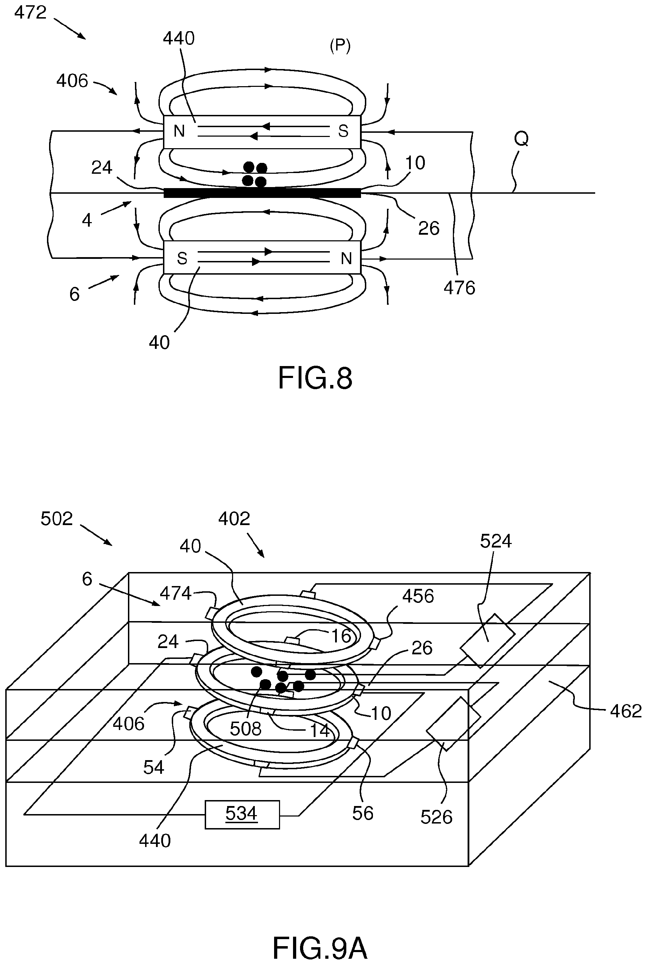

According to Figure 8, a map 472 at a given fixed time of a section of the magnetic field generated by the second magneto-resistive track 40 of the first magnetic field transmitter 6 and the third magneto-resistive track 440 of the second magnetic field transmitter 406 by a plane P, perpendicular to the extension plane Q of the first track 10 of the magnetic field receiver 4 and including the line 476 passing through the third pair of the current terminals 24, 26, exhibits a symmetry around the line 476 in a reference configuration without magnetic particle(s).

Accordingly the magnetic sensing device 402 can be used in a differential mode to detect with a high sensitivity the variation of the magnetic field close to the surface of the first track of the magnetic field receiver when magnetic particles are driven close to and above the said surface in Figure 8.

It should be noted that the tracks 40, 440 of the magnetic field transmitters can be only low resistive track made of a material such as copper, aluminum, gold or silver for example to enhance magnetic field.

According to Figure 9A and a third system embodiment, a magnetic measuring system 502 according to the invention comprises the magnetic hybrid MR/PHR based sensing device 402 as described in the Figures 7A-7B , a second track current source 524 and a third track current source 526 for supplying a DC and/or AC current respectively to the second track 40 of the first magnetic field transmitter 6 and the third track 440 of the second magnetic field transmitter 406, and a voltage measurement device 534, similar to the voltage measurement devices 264, 334 of the Figures 5A and 6A and connected between the first pair of voltage terminals 24, 26.

The magnetic measuring system 502 is configured for keeping disconnected the first pair of current terminals 14, 16 of the magnetic field receiver 4, the second pair of voltage terminals 54, 56, and the third pair of voltage terminals 454, 456, so that the impedance between the first pair of current terminals 14, 16, the impedance between the second pair of voltage terminals 54, 56, the impedance between the third pair of voltage terminals 454, 456 are representative of open circuits.

The second track current source 524 and the third track current source 526 are configured and connected to the second track of the first magnetic field transmitter and to the third track of the second magnetic field transmitter in order to generate two magnetic fields, symmetric to the plane of the magnetic field receiver and polarized with opposite direction.

The voltage measurement device 434 comprises an amplifier circuit, connected to the first and second voltage terminals 24, 26, for amplifying a measurement signal and/or cancelling an offset voltage from the said measurement signal.

In a particular embodiment, the amplifier is integrated within the magnetic sensing device 402.

Moreover, here the first spacer 462 is similar to a spacer among the described spacers of Figure 4A, 4B and 4C. Such a spacer 462 is configured to drive magnetic particles 508 in the vicinity and close to an active area of the magneto-resistive track 10 of the magnetic field receiver 4.

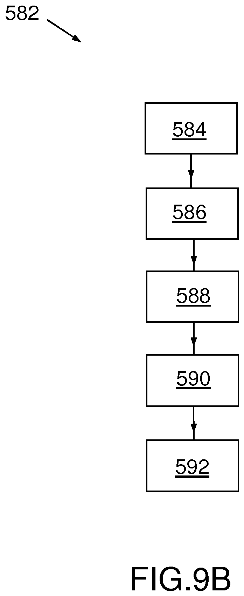

The magnetic measuring system 502 is well suited to measure local magnitude and/or variation of a magnetic field, generated closely by one or several magnetic particles and to implement a magnetic measuring method according to a third method embodiment described in Figure 9B.

The magnetic particles that can be detected by the third magnetic measuring system are the same magnetic particles that can be detected by the magnetic measuring system of Figure 6A and are listed in description of the Figure 6A.

According to Figure 9B and a third method embodiment, a magnetic measuring method 582 comprises a third set of steps for measuring local magnitude and/or variation of a magnetic field generated closely by one or several magnetic source(s).

In a first step 584, a magnetic hybrid AMR/PHR based sensing device 402 according to the second device embodiment as described in the Figures 7A-7B is provided. The magnetic sensing device 402 comprises a magnetic field receiver 4, a first magnetic field transmitter 6 and a second magnetic field transmitter 406. The magnetic sensing device 402 is configured to operate in a differential mode.

Then in a second step 586, a bias DC and/or AC current is injected in the second electromagnetic track of the first magnetic field transmitter and in the third magnetic track of the second magnetic field transmitter by using an electrical bias current source, connected between the third and fourth current terminals of the first magnetic field transmitter and between the fifth and the sixth current terminals of the second magnetic field transmitter, so that the excitation magnetic fields generated by the first magnetic field transmitter and the second magnetic field transmitter are polarized on opposite direction.

Then in a third step 588, a set of one or several magnetic particles sensitive to a magnetic field are driven in the vicinity or in contact of an active area of the magnetic receiver 4 located under the electromagnetic track 40 of the first magnetic field transmitter 6.

Then in a fourth step 590 a differential voltage V_{MR} between the first and second voltage terminals 24, 26 of the magnetic field receiver 4 is measured by a voltage measurement device, connected between the first and second voltage terminals 24, 26, while keeping disconnected the first pair of current terminals of the magnetic field receiver and the second pair of voltage terminals of the first magnetic field transmitter so that the impedance between the first pair of current terminals, and the impedance between the second pair of voltage terminals are representative of an open circuit;

Then in a fifth step 592, a local magnitude and/or a variation of a time varying magnetic field generated closely by the magnetic particles are determined on the basis of the measured differential voltage V_{MR}.

The sensing device, the magnetic measuring system, the magnetic measuring method according to the various embodiments as described here above can be used to detect and quantify a known time varying (in particular AC) magnetic field source or to detect an unknown time varying (in particular AC) magnetic field from other noise sources. There is no need to drive an electric power to the magneto-resistive AMR/HR sensor for detecting the time varying magnetic field. The use of the sensing device according to the invention can be broadened up to many fields of application requiring low power consumption sensing devices such as robotic and space applications.

For the application of gas sensing, the magnetic field receiver is used to detect the presence of the gas through a magnetic field change caused the magnetic particle(s) deposited on the sensing surface of its AMR/PHR track, while the first magnetic field transmitter is configured to generate the magnetic field. The magnetic field receiver operating as a detector detects the magnetic field signal without need of a power supply and generating an undesired thermal noise caused by a resistive Joule effect.

Accordingly the sensing device of the invention permits a decrease of its power consumption while detecting a local magnetic field with high sensitivity. As a result new applications are rendered possible to AMR/PHR sensors requiring low power consumption.

As other examples, the magnetic field sensing device according to the invention can be used for following applications:
- detection of underground electrical power line,
- detection of magnetic field generated from magnetization of magnetic materials ranging from deposited nano-particle(s) to bulk magnetic materials;
- scanning geological rock in caves;
- scanning the magnetic domains of (ferro)magnetic materials mapping the self-magnetic field generated by magnetic sensors (AMR/PHR/GMR/HaII/GMI/TMR etc...) ;
- space applications that needs to detect the magnetic field, to save mass and to operate at low temperature.

Advantageously the sensing device according to the invention is a low power consumption, small and compact device by saving the weight of the power stage supply and by allowing an operation at temperatures ranging from 4°K to 400°K. The sensing device operates within large frequency range from 1 to 10 kHz without Joule effect dissipation and any heating process.

For the same sensitivity, the sensing device according to the invention is less bulky than the conventional inductance of flux gate. The size of the sensing device is the order of the micrometer for the AMR/PHR itself and the order of the cm³ for the packaging.

In addition to its light weight the magnetic sensing device of the invention is easy to manufacture, which permits a low cost production rate for a mass production.

## Claims

1. A magnetic hybrid Magneto-Resistive/Planar Hall Resistive, AMR/PHR, based sensing device for detecting local magnitude and/or variation of a magnetic field generated remotely or closely by one or several magnetic source(s), and comprising:
- a magnetic field receiver (4), as a first component, having a structure of a magnetic hybrid Magneto-Resistive/Planar Hall Resistive, AMR/PHR, sensor and that includes
• a magnetoresistive first track (10) with a closed loop shape or a cross junction shape,
• a first pair (12) of current terminals formed with a first current terminal (14) and a second current terminal (16), facing each other, contacting with the magnetoresistive first track (10) and forming a first easy axis (18),
• a first pair (22) of voltage terminals formed with a first voltage terminal (24) and a second voltage terminal (26), facing each other, contacting with the magnetoresistive first track (10) and forming a first hard axis (28), orthogonal to the first easy axis (18),
wherein
the magnetic hybrid Magneto-Resistive/Planar Hall Resistive, AMR/PHR, based sensing device comprises:
- a first magnetic field transmitter (6) as a second component, configured for being excited by a DC and/or AC supplied bias current or by an external magnetic field to be measured and that includes
• a magnetoresistive or low resistive second track (40) with a closed loop shape or a cross junction shape,
• a second pair (42) of current terminals formed with a third current terminal (44) and a fourth current terminal (46), facing each other, contacting with the second track (40) and forming a second easy axis (48),
• a second pair (52) of voltage terminals formed with a third voltage terminal (54) and a fourth voltage terminal (56), facing each other, contacting with the second track (40) and forming a second hard axis (58), orthogonal to the second easy axis (48),
**characterized in that**
the magnetic field receiver (4) and the magnetic field transmitter (6) are superimposed, secured to and separated by a first insulating spacer (62) configured to align respectively the first easy axis (18) and the first hard axis (28) to the second easy axis (48) and the second hard axis (58), then rotate the said second axis (48, 58) from said first axis (18, 28) at a predetermines fixed offset angle *α*, and to maintain this axis arrangement as well as a fixed separation distance e₁₂ between the first track (10) and the second track (40) in a range from few micrometers to few nanometers.

2. The magnetic hybrid Magneto-Resistive/Planar Hall Resistive, AMR/PHR, based sensing device according to claim 1, wherein the first spacer (62) is a:
- a rigid structure made of a rigid insulating material having pillars and beams and/ or ribs, having voids filled by an insulating gas or vacuum; or
- a bulky homogeneous layer made of a rigid insulating material; or
- a bully layer (232) made of a rigid insulating material and pierced with at least one longitudinal hole(s) (234, 236, 238), directed along a direction (240) included in the extension plane of the layer, to drive magnetic particle(s) and without lateral opening; or
- a bulky layer (242) made of a rigid insulating material and pierced with at least one longitudinal hole(s) (244), directed along a direction (246) included in the extension plane of the layer (242), to drive magnetic particle(s), the longitudinal hole(s) (244) having lateral(s) opening (248) connected to secondary longitudinal hole(s) (250) to provide a control access for controlling a magnetic state of the particle(s); or
- a bulky layer (252) made of a rigid insulating material and pieced perpendicularly to the layer plane with at least one longitudinal hole(s) (254), when the second track (40) of the first transmitter (6) has a central opening (258).

3. The magnetic hybrid Magneto-Resistive/Planar Hall Resistive, AMR/PHR, based sensing device according to any of claims 1 to 2, wherein
the rigid insulating material of the first spacer (62) is comprised among the dioxide of silicon SiO₂, and/or
the thickness e₁₂ of the insulating layer of the first spacer (62) is ranging from 1 µm to 5 µm, or from 600 nm to 1 µm, or from 200 nm to 600 nm, or from 50 nm to 200 nm, or from 10 nm to 50 nm, or from 1 nm to 10 nm.

4. The magnetic hybrid Magneto-Resistive/Planar Hall Resistive, AMR/PHR, based sensing device according to any of claims 1 to 3, wherein the shape of the track (10) of the magnetic field receiver (4) and the shape of the track (40) of the first magnetic field transmitter (6) are shapes comprised in the set of the closed loop shapes among the shapes of a ring junction, a multi-ring junction (170), an oval junction (180), a multi-oval junction, a diamond junction (200), a multi-diamond junction (210), a square junction (200), a multi-square junction, a rectangular junction, a multi-rectangular junction, and the shape of a cross junction (220).

5. The magnetic hybrid Magneto-Resistive/Planar Hall Resistive, AMR/PHR, based sensing device according to any of claims 1 to 4, wherein
the material of the first track (10) is a magneto-resistive material among the bi-layer structure material, in particular Ta/NiFe/IrMn/Ta, a tri-layer structure material including a ferromagnetic film, a metal and an anti-ferromagnetic film, in particular Ta/NiFe/Cu/IrMn/Ta, and a spin-valve structure material, in particular Ta/NiFe/Cu/NiFe/IrMn/Ta; and
the material of the second track (40) is a magneto-resistive material among a bi-layer structure material, in particular Ta/NiFe/IrMn/Ta, a tri-layer structure material including a ferromagnetic film, a metal and an anti-ferromagnetic film, in particular Ta/NiFe/Cu/IrMn/Ta, and a spin-valve structure material, in particular Ta/NiFe/Cu/NiFe/IrMn/Ta, or is a low resistive material among gold, copper and silver metals.

6. The magnetic hybrid Magneto-Resistive/Planar Hall Resistive, AMR/PHR, based sensing device according to any of claims 1 to 5, wherein the offset angle α formed between the first easy axis (18) of the magnetic field receiver and the second easy axis (48) of the first field transmitter is selected in the range [0 degree, 90 degrees] so that the sensitivity of the sensing device is maximal, and preferably is comprised within the range [15 degrees, 25 degrees].

7. The magnetic hybrid Magneto-Resistive/Planar Hall Resistive, AMR/PHR, based sensing device according to any of claims 1 to 6, wherein the accuracy of the alignment of the axis before their rotation is below 10 nm, and the accuracy of the set α angle is below 1.0 degree, preferably below 0.02 degree.

8. The magnetic hybrid Magneto-Resistive/Planar Hall Resistive, AMR/PHR, based sensing device according to any of claims 1 to 7, wherein
the magnetic field receiver (4) and the first magnetic field transmitter (6) are identical, or
the magnetic field receiver (4) and the first magnetic field transmitter (6) mutually differ by the shape of their electromagnetic track (10, 40), and/or the material of their electromagnetic track (10, 40).

9. The magnetic hybrid Magneto-Resistive/Planar Hall Resistive, AMR/PHR, based sensing device according to any of claims 1 to 8, comprising further
- a second magnetic field transmitter (406) as a third component, configured for being excited by a DC and/or AC supplied bias current or by an external magnetic field to be measured and that includes
• a magnetoresistive or low resistive third track (440) with a closed loop shape or a cross junction shape,
• a third pair (442) of current terminals formed with a fifth current terminal (444) and a sixth current terminal (446), facing each other, contacting with the third track (440) and forming a third easy axis (448),
• a third pair (452) of voltage terminals formed with a fifth voltage terminal (454) and a sixth voltage terminal (456), facing each other, contacting with the third track (440) and forming a third hard axis (458), orthogonal to the third easy axis (448), and
wherein
the first magnetic field transmitter (6) and the second magnetic field transmitter (406) are identical, and
the first magnetic field transmitter (6), the magnetic field receiver (4) and the second magnetic field transmitter (406) are superimposed and mutually secured through the first spacer (62) and a second spacer (462) so that the field magnetic receiver (4) is sandwiched between the first field magnetic transmitter (6) and the second field magnetic transmitter (406).

10. The magnetic hybrid Magneto-Resistive/Planar Hall Resistive, AMR/PHR based sensing device according to the claim 9, wherein
the second insulating spacer (462) is configured to secure the second magnetic field transmitter (406) to the magnetic field receiver (4) on the opposite side of the first insulating spacer (62), once an alignment of the respective first easy axis (18) and the first hard axis (28) to the respective third easy axis (448) and the third hard axis (458), followed by a rotation of the said third axis from the said first axis at the predetermined fixed offset angle α, and to maintain this axis arrangement as well as a fixed separation distance e₁₃ between the first track (10) and the third track (440) equal to the fixed separation distance e₁₂ between the first track (10) and the second track (40); and
the second spacer (462) is a bulky homogeneous layer made of the rigid insulating material as the insulating material of the first spacer (62).

11. The magnetic hybrid Magneto-Resistive/Planar Hall Resistive, MR/PHR, based sensing device according any of claims 1 to 10, comprising further
either a single second track current source (324) for supplying a DC and/or AC current to the second track (40) of the first magnetic field transmitter (6) when the magnetic sensing device comprises the magnetic field receiver and the first magnetic field transmitter as a single magnetic field transmitter,
or a second track current source (524) and a third track current source (526) for supplying a DC and/or AC current respectively to the second track (40) of the first magnetic field transmitter (6) and to the third track (440) of the second magnetic field transmitter (406) when the magnetic sensing device comprises the magnetic field receiver and two first and second magnetic field transmitter to operate in a differential mode, the second track current source and the third track current source being configured and connected to the second track of the first magnetic field transmitter and to the third track of the second magnetic field transmitter in order to generate two magnetic fields, symmetric to the plane of the magnetic field receiver and polarized with opposite direction.

12. The magnetic hybrid Magneto-Resistive/Planar Hall Resistive, AMR/PHR, based sensing device according any of claims 1 to 11, comprising further an amplifier circuit connected to the first and second voltage terminals for amplifying a measurement signal and/or cancel a offset voltage from the said measurement signal.

13. A magnetic measuring method for measuring local magnitude and/or variation of a magnetic field generated remotely or closely by one or several magnetic source(s),
the magnetic measuring method comprising the steps of :
- providing (304) a magnetic hybrid Magneto-Resistive/Planar Hall Resistive, AMR/PHR, based sensing device (2) comprising a magnetic field receiver (4) and a first magnetic field transmitter (6) as defined in any of claims 1 to 8,
- measuring (306) a differential voltage V_{MR} between the voltage terminals of the first pair by using a voltage measurement device connected between the first and second voltage terminals, while keeping disconnected the first pair of current terminals of the magnetic field receiver, the first pair of voltage terminals of the magnetic field receiver, and the second pair of current terminals of the first magnetic field transmitter so that the impedance between the first pair of current terminals, the impedance between the first pair of voltage terminals, the impedance between the second pair of current terminals are representative of an open circuit;
- determining (308) a local magnitude and/or variation of a time varying magnetic field generated remotely or closely by one or several magnetic source(s) on the basis of the measured differential voltage.

14. A magnetic measuring method for measuring local magnitude and/or variation of a magnetic field generated closely by one or several magnetic source(s),
the magnetic measuring method comprising the steps of :
- providing (354) a magnetic hybrid Magneto-Resistive/Planar Hall Resistive, AMR/PHR, based sensing device comprising a magnetic field receiver and a first magnetic field transmitter as defined in any of claims 1 to 8,
- injecting (356) a bias DC and/or AC current in the second magnetic track of the first magnetic field transmitter by using an electrical bias current source connected between the third and fourth current terminals of the first magnetic field transmitter, and
- driving (358) a set of one or several magnetic particles sensitive to a magnetic field in the vicinity or in contact of an active area of the magnetic receiver located under the magnetic track of the first magnetic field transmitter; then
- measuring (360) a differential voltage V_{MR} between the first and second voltage terminals of the magnetic field receiver by using a voltage measurement device connected between the first and second voltage terminals, while keeping disconnected the first pair of current terminals of the magnetic field receiver and the second pair of voltage terminals of the first magnetic field transmitter so that the impedance between the first pair of current terminals, and the impedance between the second pair of voltage terminals are representative of an open circuit;
- determining (362) a local magnitude and/or variation of a time varying magnetic field generated closely by the magnetic particles on the basis of the measured differential voltage.

15. A magnetic measuring method for measuring local magnitude and/or variation of a magnetic field generated closely by one or several magnetic source(s),
the magnetic measuring method comprising the steps of :
- providing (584) a magnetic hybrid Magneto-Resistive/Planar Hall Resistive, AMR/PHR, based sensing device comprising a magnetic field receiver, a first magnetic field transmitter and a second magnetic field transmitter as defined in any of claims 9 to 10,
- injecting (586) a bias DC and/or AC current in the second magnetic track of the first magnetic field transmitter and the third magnetic track of the second magnetic field transmitter by using an electrical bias current source connected between the third and fourth current terminals of the first magnetic field transmitter and between the fifth and the sixth current terminals of the second magnetic field transmitter so that the excitation magnetic fields generated by the first magnetic field transmitter and the second magnetic field transmitter are polarized on opposite direction, and
- driving (588) a set of one or several magnetic particles sensitive to a magnetic field in the vicinity or in contact of an active area of the magnetic receiver located under the magnetic track of the first magnetic field transmitter; then
- measuring (590) a differential voltage V_{MR} between the first and second voltage terminals of the magnetic field receiver by using a voltage measurement device connected between the first and second voltage terminals, while keeping disconnected the first pair of current terminals of the magnetic field receiver and the second pair of voltage terminals of the first magnetic field transmitter so that the impedance between the first pair of current terminals, and the impedance between the second pair of voltage terminals are representative of an open circuit;
- determining (592) a local magnitude and/or variation of a time varying magnetic field generated closely by the magnetic particles on the basis of the measured differential voltage.

## Patentansprüche

1. Magnetische Hybrid-Magneto-Widerstands-/Planar-Hall-Widerstand-basierte, AMR/PHR-basierte, Sensorvorrichtung zum Erfassen der lokalen Größe und/oder Variation eines Magnetfelds, das entfernt oder in der Nähe von einer oder mehreren Magnetquellen erzeugt wird, und umfassend:
- einen Magnetfeldempfänger (4) als erste Komponente mit einer Struktur eines magnetischen Hybrid-Magneto-Widerstands-/Planar-Hall-Widerstand-Sensors, AMR/PHR-Sensors, und der Folgendes beinhaltet
• eine magnetoresistive erste Spur (10) in Form einer geschlossenen Schleife oder in Form einer Kreuzung,
• ein erstes Paar (12) von Stromanschlüssen, die mit einem ersten Stromanschluss (14) und einem zweiten Stromanschluss (16) ausgebildet sind, die einander gegenüberliegen, mit der magnetoresistiven ersten Spur (10) in Kontakt stehen und eine erste leichte Achse (18) bilden,
• ein erstes Paar (22) von Spannungsanschlüssen, die mit einem ersten Spannungsanschluss (24) und einem zweiten Spannungsanschluss (26) ausgebildet sind, die einander gegenüberliegen, mit der magnetoresistiven ersten Spur (10) in Kontakt stehen und eine erste harte Achse (28) bilden, die senkrecht zur ersten leichten Achse (18) steht,
wobei
die magnetische Hybrid-Magneto-Widerstands-/Planar-Hall-Widerstand-basierte, AMR/PHR-basierte, Sensorvorrichtung umfasst:
- einen ersten Magnetfeldgeber (6) als zweite Komponente, der dazu konfiguriert ist, durch einen von Gleich- und/oder Wechselstrom gespeisten Vorspannungsstrom oder durch ein zu messendes externes Magnetfeld angeregt zu werden, und der Folgendes beinhaltet:
• eine magnetoresistive oder niederohmige zweite Spur (40) in Form einer geschlossenen Schleife oder in Form einer Kreuzung,
• ein zweites Paar (42) von Stromanschlüssen, die mit einem dritten Stromanschluss (44) und einem vierten Stromanschluss (46) ausgebildet sind, die einander gegenüberliegen, mit der zweiten Spur (40) in Kontakt stehen und eine zweite leichte Achse (48) bilden,
• ein zweites Paar (52) von Spannungsanschlüssen, die mit einem dritten Spannungsanschluss (54) und einem vierten Spannungsanschluss (56) ausgebildet sind, die einander gegenüberliegen, mit der zweiten Spur (40) in Kontakt stehen und eine zweite harte Achse (58) bilden, die senkrecht zur zweiten leichten Achse (48) steht,
**dadurch gekennzeichnet, dass**
der Magnetfeldempfänger (4) und der Magnetfeldgeber (6) von einem ersten isolierenden Abstandshalter (62) überlagert, daran befestigt sind und getrennt werden, der dazu konfiguriert ist, die erste leichte Achse (18) bzw. die erste harte Achse (28) auf die zweite leichte Achse (48) bzw. die zweite harte Achse (58) auszurichten, dann die zweite Achse (48, 58) von der ersten Achse (18, 28) in einem vorgegebenen festen Versatzwinkel α wegzudrehen und diese Achsenanordnung sowie einen festen Trennungsabstand e₁₂ zwischen der ersten Spur (10) und der zweiten Spur (40) in einem Bereich von wenigen Mikrometern bis zu wenigen Nanometern beizubehalten.

2. Magnetische Hybrid-Magneto-Widerstands-/Planar-Hall-Widerstand-basierte, AMR/PHR-basierte, Sensorvorrichtung nach Anspruch 1, wobei der erste Abstandshalter (62) Folgendes ist:
- eine starre Struktur, die aus einem starren Isoliermaterial mit Säulen und Trägern und/oder Rippen hergestellt ist, der Hohlräume aufweist, die mit einem Isoliergas oder Vakuum gefüllt sind; oder
- eine voluminöse homogene Schicht, die aus einem starren Isoliermaterial hergestellt ist; oder
- eine voluminöse Schicht (232), die aus einem starren Isoliermaterial hergestellt ist, die mit mindestens einem oder mehreren Langlöchern (234, 236, 238) durchstochen ist, die entlang einer in der Ausdehnungsebene der Schicht enthaltenen Richtung (240) gerichtet sind, um eine oder mehrere Magnetpartikeln anzutreiben, und ohne seitliche Öffnung; oder
- eine voluminöse Schicht (242), die aus einem starren Isoliermaterial hergestellt ist, die mit mindestens einem oder mehreren Langlöchern (244) durchstochen ist, die entlang einer in der Ausdehnungsebene der Schicht (242) enthaltenen Richtung (246) gerichtet sind, um eine oder mehrere Magnetpartikeln anzutreiben, wobei das oder die Langlöcher (244) eine oder mehrere seitliche Öffnungen (248) aufweisen, die mit dem oder den sekundären Langlöchern (250) verbunden sind, um einen Steuerzugang zum Steuern eines magnetischen Zustands des oder der Partikeln bereitzustellen; oder
- eine voluminöse Schicht (252), die aus einem starren Isoliermaterial hergestellt ist, die senkrecht zur Schichtebene mit mindestens einem oder mehreren Langlöchern (254) durchstochen ist, wenn die zweite Spur (40) des ersten Gebers (6) eine zentrale Öffnung (258) aufweist.

3. Magnetische Hybrid-Magneto-Widerstands-/Planar-Hall-Widerstand-basierte, AMR/PHR-basierte, Sensorvorrichtung nach einem der Ansprüche 1 bis 2, wobei
das starre Isoliermaterial des ersten Abstandhalters (62) aus dem Siliziumdioxid SiO₂ umfasst ist, und/oder
die Dicke e₁₂ der Isolierschicht des ersten Abstandhalters (62) von 1 µm bis 5 µm oder von 600 nm bis 1 µm oder von 200 nm bis 600 nm oder von 50 nm bis 200 nm oder von 10 nm bis 50 nm oder von 1 nm bis 10 nm reicht.

4. Magnetische Hybrid-Magneto-Widerstands-/Planar-Hall-Widerstand-basierte, AMR/PHR-basierte, Sensorvorrichtung nach einem der Ansprüche 1 bis 3, wobei die Form der Spur (10) des Magnetfeldempfängers (4) und die Form der Spur (40) des ersten Magnetfeldgebers (6) Formen sind, die im Satz der geschlossenen Schleifenformen unter den Formen einer Ringverbindung, einer Mehrfach-Ringverbindung (170), einer ovalen Verbindung (180), einer mehrfach ovalen Verbindung, einer Rautenverbindung (200), einer Mehrfach-Rautenverbindung (210), einer quadratischen Verbindung (200), einer Mehrfach-Quadratverbindung, einer rechteckigen Verbindung, einer Mehrfach-Rechteckverbindung und der Form einer Kreuzverbindung (220) enthalten sind.

5. Magnetische Hybrid-Magneto-Widerstands-/Planar-Hall-Widerstand-basierte, AMR/PHR-basierte, Sensorvorrichtung nach einem der Ansprüche 1 bis 4, wobei
das Material der ersten Spur (10) ein magnetoresistives Material unter dem Zweischicht-Strukturmaterial, insbesondere Ta/NiFe/IrMn/Ta, ein Dreischicht-Strukturmaterial mit einem ferromagnetischen Film, einem Metall und einem antiferromagnetischen Film, insbesondere Ta/NiFe/Cu/IrMn/Ta, und ein Spinventil-Strukturmaterial, insbesondere Ta/NiFe/Cu/NiFe/IrMn/Ta, ist; und
das Material der zweiten Spur (40) ein magnetoresistives Material unter einem Zweischicht-Strukturmaterial, insbesondere Ta/NiFe/IrMn/Ta, ein Dreischicht-Strukturmaterial mit einem ferromagnetischen Film, einem Metall und einem antiferromagnetischen Film, insbesondere Ta/NiFe/Cu/IrMn/Ta, und ein Spinventil-Strukturmaterial, insbesondere Ta/NiFe/Cu/NiFe/IrMn/Ta, ist, oder ein niederohmiges Material unter Gold, Kupfer und Silbermetallen ist.

6. Magnetische Hybrid-Magneto-Widerstands-/Planar-Hall-Widerstand-basierte, AMR/PHR-basierte, Sensorvorrichtung nach einem der Ansprüche 1 bis 5, wobei der zwischen der ersten leichten Achse (18) des Magnetfeldempfängers und der zweiten leichten Achse (48) des ersten Feldgebers gebildete Versatzwinkel α im Bereich von [0 Grad, 90 Grad] so gewählt ist, dass die Empfindlichkeit der Sensorvorrichtung maximal ist und vorzugsweise im Bereich von [15 Grad, 25 Grad] liegt.

7. Magnetische Hybrid-Magneto-Widerstands-/Planar-Hall-Widerstand-basierte, AMR/PHR-basierte, Sensorvorrichtung nach einem der Ansprüche 1 bis 6, wobei die Genauigkeit der Ausrichtung der Achse vor ihrer Drehung unter 10 nm liegt und die Genauigkeit des eingestellten Winkels α unter 1,0 Grad, vorzugsweise unter 0,02 Grad liegt.

8. Magnetische Hybrid-Magneto-Widerstands-/Planar-Hall-Widerstand-basierte, AMR/PHR-basierte, Sensorvorrichtung nach einem der Ansprüche 1 bis 7, wobei
der Magnetfeldempfänger (4) und der erste Magnetfeldgeber (6) identisch sind, oder
der Magnetfeldempfänger (4) und der erste Magnetfeldgeber (6) sich durch die Form ihrer elektromagnetischen Spur (10, 40) und/oder das Material ihrer elektromagnetischen Spur (10, 40) voneinander unterscheiden.

9. Magnetische Hybrid-Magneto-Widerstands-/Planar-Hall-Widerstand-basierte, AMR/PHR-basierte, Sensorvorrichtung nach einem der Ansprüche 1 bis 8, ferner umfassend:
- einen zweiten Magnetfeldgeber (406) als dritte Komponente, der dazu konfiguriert ist, durch einen von Gleich- und/oder Wechselstrom gespeisten Vorspannungsstrom oder durch ein zu messendes externes Magnetfeld angeregt zu werden, und der Folgendes beinhaltet:
• eine magnetoresistive oder niederohmige dritte Spur (440) in Form einer geschlossenen Schleife oder in Form einer Kreuzung,
• ein drittes Paar (442) von Stromanschlüssen, die mit einem fünften Stromanschluss (444) und einem sechsten Stromanschluss (446) ausgebildet sind, die einander gegenüberliegen, mit der dritten Spur (440) in Kontakt stehen und eine dritte leichte Achse (448) bilden,
• ein drittes Paar (452) von Spannungsanschlüssen, die mit einem fünften Spannungsanschluss (454) und einem sechsten Spannungsanschluss (456) ausgebildet sind, die einander gegenüberliegen, mit der dritten Spur (440) in Kontakt stehen und eine dritte harte Achse (458) bilden, die orthogonal zur dritten leichten Achse (448) steht, und wobei
der erste Magnetfeldgeber (6) und der zweite Magnetfeldgeber (406) identisch sind, und
der erste Magnetfeldgeber (6), der Magnetfeldempfänger (4) und der zweite Magnetfeldgeber (406) überlagert und durch den ersten Abstandshalter (62) und einen zweiten Abstandshalter (462) aneinander befestigt sind, so dass der Magnetfeldempfänger (4) zwischen dem ersten Magnetfeldgeber (6) und dem zweiten Magnetfeldgeber (406) eingeklemmt ist.

10. Magnetische Hybrid-Magneto-Widerstands-/Planar-Hall-Widerstand-basierte, AMR/PHR-basierte, Sensorvorrichtung nach Anspruch 9, wobei
der zweite isolierende Abstandshalter (462) dazu konfiguriert ist, den zweiten Magnetfeldgeber (406) am Magnetfeldempfänger (4) auf der gegenüberliegenden Seite des ersten isolierenden Abstandshalters (62) zu befestigen, nachdem eine Ausrichtung der entsprechenden ersten leichten Achse (18) und der ersten harten Achse (28) auf die entsprechende dritte leichte Achse (448) und die dritte harte Achse (458) erfolgt ist, gefolgt von einer Drehung der dritten Achse von der ersten Achse um den vorgegebenen festen Versatzwinkel α, und um diese Achsenanordnung beizubehalten, sowie einen festen Trennabstand e₁₃ zwischen der ersten Spur (10) und der dritten Spur (440), der dem festen Trennabstand e₁₂ zwischen der ersten Spur (10) und der zweiten Spur (40) entspricht; und
der zweite Abstandshalter (462) eine voluminöse homogene Schicht ist, die aus dem starren Isoliermaterial als Isoliermaterial des ersten Abstandshalters (62) hergestellt ist.

11. Magnetische Hybrid-Magneto-Widerstands-/Planar-Hall-Widerstand-basierte, AMR/PHR-basierte, Sensorvorrichtung nach einem der Ansprüche 1 bis 10, ferner umfassend:
entweder eine einzelne Stromquelle für die zweite Spur (324) zum Zuführen eines Gleich- und/oder Wechselstroms zu der zweiten Spur (40) des ersten Magnetfeldgebers (6), wenn die Magnetsensorvorrichtung den Magnetfeldempfänger und den ersten Magnetfeldgeber als einen einzelnen Magnetfeldgeber umfasst,
oder eine Stromquelle für die zweite Spur (524) und eine Stromquelle für die dritte Spur (526) zum Zuführen eines Gleich- und/oder Wechselstroms zur zweiten Spur (40) des ersten Magnetfeldgebers (6) bzw. zur dritten Spur (440) des zweiten Magnetfeldgebers (406), wenn die Magnetsensorvorrichtung den Magnetfeldempfänger und zwei erste und zweite Magnetfeldgeber zum Betrieb in einem Differenzmodus umfasst, wobei die Stromquelle für die zweite Spur und die Stromquelle für die dritte Spur konfiguriert und mit der zweiten Spur des ersten Magnetfeldgebers und mit der dritten Spur des zweiten Magnetfeldgebers verbunden sind, um zwei Magnetfelder zu erzeugen, die symmetrisch zur Ebene des Magnetfeldempfängers und mit entgegengesetzter Richtung polarisiert sind.

12. Magnetische Hybrid-Magneto-Widerstands-/Planar-Hall-Widerstand-basierte, AMR/PHR-basierte, Sensorvorrichtung nach einem der Ansprüche 1 bis 11, ferner umfassend eine Verstärkerschaltung, die mit dem ersten und zweiten Spannungsanschluss verbunden ist, um ein Messsignal zu verstärken und/oder eine Offsetspannung aus dem Messsignal zu löschen.

13. Magnetisches Messverfahren zum Messen der lokalen Größe und/oder Variation eines Magnetfeldes, das von einer oder mehreren magnetischen Quellen entfernt oder in der Nähe erzeugt wird,
wobei das magnetische Messverfahren die folgenden Schritte umfasst:
- Bereitstellen (304) einer magnetischen Hybrid-Magneto-Widerstands-/Planar-Hall-Widerstand-basierten, AMR/PHR-basierten, Sensorvorrichtung (2), die einen Magnetfeldempfänger (4) und einen ersten Magnetfeldgeber (6) nach einem der Ansprüche 1 bis 8 umfasst,
- Messen (306) einer Differenzspannung V_{MR} zwischen den Spannungsanschlüssen des ersten Paares unter Verwendung einer Spannungsmessvorrichtung, die zwischen dem ersten und zweiten Spannungsanschluss angeschlossen ist, während das erste Paar von Stromanschlüssen des Magnetfeldempfängers, das erste Paar von Spannungsanschlüssen des Magnetfeldempfängers und das zweite Paar von Stromanschlüssen des ersten Magnetfeldgebers getrennt bleiben, so dass die Impedanz zwischen dem ersten Paar von Stromanschlüssen, die Impedanz zwischen dem ersten Paar von Spannungsanschlüssen, die Impedanz zwischen dem zweiten Paar von Stromanschlüssen einen offenen Stromkreis darstellen;
- Bestimmen (308) einer lokalen Größe und/oder Variation eines zeitveränderlichen Magnetfeldes, das von einer oder mehreren magnetischen Quellen auf der Basis der gemessenen Differenzspannung entfernt oder in der Nähe erzeugt wird.

14. Magnetisches Messverfahren zum Messen der lokalen Größe und/oder Variation eines Magnetfeldes, das von einer oder mehreren magnetischen Quellen in der Nähe erzeugt wird,
wobei das magnetische Messverfahren die folgenden Schritte umfasst:
- Bereitstellen (354) einer magnetischen Hybrid-Magneto-Widerstands-/Planar-Hall-Widerstand-basierten, AMR/PHR-basierten, Sensorvorrichtung, die einen Magnetfeldempfänger und einen ersten Magnetfeldgeber nach einem der Ansprüche 1 bis 8 umfasst,
- Einspeisen (356) eines Vorspannungs-Gleich- und/oder Wechselstroms in die zweite Magnetspur des ersten Magnetfeldgebers unter Verwendung einer elektrischen Vorspannungsstromquelle, die zwischen dem dritten und vierten Stromanschluss des ersten Magnetfeldgebers angeschlossen ist, und
- Antreiben (358) eines Satzes von einem oder mehreren Magnetpartikeln, die auf ein Magnetfeld in der Nähe oder in Kontakt mit einem aktiven Bereich des Magnetempfängers reagieren, der sich unter der Magnetspur des ersten Magnetfeldgebers befindet; dann
- Messen (360) einer Differenzspannung V_{MR} zwischen dem ersten und zweiten Spannungsanschluss des Magnetfeldempfängers unter Verwendung einer Spannungsmessvorrichtung, die zwischen dem ersten und zweiten Spannungsanschluss angeschlossen ist, während das erste Paar von Stromanschlüssen des Magnetfeldempfängers und das zweite Paar von Spannungsanschlüssen des ersten Magnetfeldgebers getrennt bleiben, so dass die Impedanz zwischen dem ersten Paar von Stromanschlüssen und die Impedanz zwischen dem zweiten Paar von Spannungsanschlüssen einen offenen Stromkreis darstellen;
- Bestimmen (362) einer lokalen Größe und/oder Variation eines zeitveränderlichen Magnetfeldes, das von den Magnetpartikeln auf der Basis der gemessenen Differenzspannung in der Nähe erzeugt wird.

15. Magnetisches Messverfahren zum Messen der lokalen Größe und/oder Variation eines Magnetfeldes, das von einer oder mehreren magnetischen Quellen in der Nähe erzeugt wird,
wobei das magnetische Messverfahren die folgenden Schritte umfasst:
- Bereitstellen (584) einer magnetischen Hybrid-Magneto-Widerstands-/Planar-Hall-Widerstand-basierten, AMR/PHR-basierten, Sensorvorrichtung, die einen Magnetfeldempfänger, einen ersten Magnetfeldgeber und einen zweiten Magnetfeldgeber nach einem der Ansprüche 9 bis 10 umfasst,
- Einspeisen (586) eines Vorspannungs-Gleich- und/oder Wechselstroms in die zweite Magnetspur des ersten Magnetfeldgebers und die dritte Magnetspur des zweiten Magnetfeldgebers unter Verwendung einer elektrischen Vorspannungsstromquelle, die zwischen dem dritten und vierten Stromanschluss des ersten Magnetfeldgebers und zwischen dem fünften und sechsten Stromanschluss des zweiten Magnetfeldgebers angeschlossen ist, so dass die vom ersten Magnetfeldgeber und dem zweiten Magnetfeldgeber erzeugten Erregungsmagnetfelder entgegengesetzt polarisiert sind, und
- Antreiben (588) eines Satzes von einem oder mehreren Magnetpartikeln, die auf ein Magnetfeld in der Nähe oder in Kontakt mit einem aktiven Bereich des Magnetempfängers reagieren, der sich unter der Magnetspur des ersten Magnetfeldgebers befindet; dann
- Messen (590) einer Differenzspannung V_{MR} zwischen dem ersten und zweiten Spannungsanschluss des Magnetfeldempfängers unter Verwendung einer Spannungsmessvorrichtung, die zwischen dem ersten und zweiten Spannungsanschluss angeschlossen ist, während das erste Paar von Stromanschlüssen des Magnetfeldempfängers und das zweite Paar von Spannungsanschlüssen des ersten Magnetfeldgebers getrennt bleiben, so dass die Impedanz zwischen dem ersten Paar von Stromanschlüssen und die Impedanz zwischen dem zweiten Paar von Spannungsanschlüssen einen offenen Stromkreis darstellen;
- Bestimmen (592) einer lokalen Größe und/oder Variation eines zeitveränderlichen Magnetfeldes, das von den Magnetpartikeln auf der Basis der gemessenen Differenzspannung in der Nähe erzeugt wird.

## Revendications

1. Dispositif de détection basé sur une magnétorésistance/une résistance à effet Hall planaire, AMR/PHR, hybride magnétique pour détecter une amplitude locale et/ou une variation d'un champ magnétique généré à distance ou à proximité par une ou plusieurs sources magnétiques, et comprenant :
- un récepteur de champ magnétique (4), en tant que premier composant, présentant une structure d'un capteur à magnétorésistance/résistance à effet Hall planaire, AMR/PHR, hybride magnétique, et qui inclut
• une première piste magnétorésistive (10) présentant une forme de boucle fermée ou une forme de jonction transversale ;
• une première paire (12) de bornes de courant, formée avec une première borne de courant (14) et une deuxième borne de courant (16), qui se font mutuellement face, en contact avec la première piste magnétorésistive (10) et formant un premier axe aisé (18) ;
• une première paire (22) de bornes de tension formée avec une première borne de tension (24) et une deuxième borne de tension (26), qui se font mutuellement face, en contact avec la première piste magnétorésistive (10) et formant un premier axe difficile (28), orthogonal au premier axe aisé (18),
dans lequel
le dispositif de détection basé sur une magnétorésistance/une résistance à effet Hall planaire, AMR/PHR, hybride magnétique comprend :
- un premier émetteur de champ magnétique (6), en tant que deuxième composant, configuré pour être excité par un courant de polarisation alimenté en courant continu et/ou en courant alternatif ou par un champ magnétique externe à mesurer, et qui inclut :
• une deuxième piste magnétorésistive ou faiblement résistive (40) présentant une forme de boucle fermée ou une boucle de jonction transversale ;
• une deuxième paire (42) de bornes de courant formée avec une troisième borne de courant (44) et une quatrième borne de courant (46), qui se font mutuellement face, en contact avec la deuxième piste (40) et formant un deuxième axe aisé (48) ;
• une deuxième paire (52) de bornes de tension formée avec une troisième borne de tension (54) et une quatrième borne de tension (56), qui se font mutuellement face, en contact avec la deuxième piste (40) et formant un deuxième axe difficile (58), orthogonal au deuxième axe aisé (48) ;
**caractérisé en ce que** :
le récepteur de champ magnétique (4) et l'émetteur de champ magnétique (6) sont superposés, fixés à, et séparés par un premier élément d'espacement isolant (62) configuré pour aligner respectivement le premier axe aisé (18) et le premier axe difficile (28) sur le deuxième axe aisé (48) et le deuxième axe difficile (58), et ensuite à faire tourner ledit deuxième axe (48, 58) par rapport audit premier axe (18, 28) selon un angle de décalage fixe prédéterminé a, et à maintenir cet agencement d'axes ainsi qu'une distance de séparation fixe e₁₂ entre la première piste (10) et la deuxième piste (40) dans une plage allant de quelques micromètres à quelques nanomètres.

2. Dispositif de détection basé sur une magnétorésistance/une résistance à effet Hall planaire, AMR/PHR, hybride magnétique selon la revendication 1, dans lequel le premier élément d'espacement (62) est :
- une structure rigide constituée d'un matériau isolant rigide présentant des piliers et des poutres et/ou des nervures, présentant des vides remplis par un gaz isolant ou un vide ; ou
- une couche homogène volumineuse constituée d'un matériau isolant rigide ; ou
- une couche volumineuse (232) constituée d'un matériau isolant rigide, et percée d'au moins un ou plusieurs trous longitudinaux (234, 236, 238), orientés le long d'une direction (240) incluse dans le plan d'extension de la couche, pour entraîner une ou des particules magnétiques, et sans ouverture latérale ; ou
- une couche volumineuse (242) constituée d'un matériau isolant rigide, et percée d'au moins un ou plusieurs trous longitudinaux (244), orientés le long d'une direction (246) incluse dans le plan d'extension de la couche (242), pour entraîner une ou des particules magnétiques, le ou les trous longitudinaux (244) présentant une ou des ouvertures latérales (248) reliées à un ou des trous longitudinaux secondaires (250) en vue de fournir un accès de contrôle pour contrôler un état magnétique de la ou des particules ; ou
- une couche volumineuse (252) constituée d'un matériau isolant rigide, et percée, perpendiculairement au plan de couche, d'au moins un ou plusieurs trous longitudinaux (254), lorsque la deuxième piste (40) du premier émetteur (6) présente une ouverture centrale (258).

3. Dispositif de détection basé sur une magnétorésistance/une résistance à effet Hall planaire, AMR/PHR, hybride magnétique selon l'une quelconque des revendications 1 à 2, dans lequel
le matériau isolant rigide du premier élément d'espacement (62) est compris parmi le dioxyde de silicium, SiO₂; et/ou
l'épaisseur e₁₂ de la couche isolante du premier élément d'espacement (62) est comprise entre 1 µm et 5 µm, ou entre 600 nm et 1 µm, ou entre 200 nm et 600 nm, ou entre 50 nm et 200 nm, ou entre 10 nm et 50 nm, ou entre 1 nm et 10 nm.

4. Dispositif de détection basé sur une magnétorésistance/une résistance à effet Hall planaire, AMR/PHR, hybride magnétique selon l'une quelconque des revendications 1 à 3, dans lequel la forme de la piste (10) du récepteur de champ magnétique (4) et la forme de la piste (40) du premier émetteur de champ magnétique (6) sont des formes comprises dans l'ensemble des formes de boucle fermée parmi les formes d'une jonction annulaire, d'une jonction à anneaux multiples (170), d'une jonction ovale (180), d'une jonction à ovales multiples, d'une jonction diamant (200), d'une jonction à diamants multiples (210), d'une jonction carrée (200), d'une jonction à carrés multiples, d'une jonction rectangulaire, d'une jonction multi-rectangulaire, et la forme d'une jonction transversale (220).

5. Dispositif de détection basé sur une magnétorésistance/une résistance à effet Hall planaire, AMR/PHR, hybride magnétique selon l'une quelconque des revendications 1 à 4, dans lequel :
le matériau de la première piste (10) est un matériau magnétorésistif parmi le matériau de structure bicouche, en particulier Ta/NiFe/IrMn/Ta, un matériau de structure à trois couches incluant un film ferromagnétique, un métal et un film antiferromagnétique, en particulier Ta/NiFe/Cu/IrMn/Ta, et un matériau de structure à vanne de spin, en particulier Ta/NiFe/Cu/NiFe/IrMn/Ta ; et
le matériau de la deuxième piste (40) est un matériau magnétorésistif parmi un matériau de structure bicouche, en particulier Ta/NiFe/IrMn/Ta, un matériau de structure à trois couches incluant un film ferromagnétique, un métal et un film antiferromagnétique, en particulier Ta/NiFe/Cu/IrMn/Ta, et un matériau de structure à vanne de spin, en particulier Ta/NiFe/Cu/NiFe/IrMn/Ta, ou est un matériau faiblement résistif parmi les métaux suivants : l'or, le cuivre et l'argent.

6. Dispositif de détection basé sur une magnétorésistance/une résistance à effet Hall planaire, AMR/PHR, hybride magnétique selon l'une quelconque des revendications 1 à 5, dans lequel l'angle de décalage α formé entre le premier axe aisé (18) du récepteur de champ magnétique et le deuxième axe aisé (48) du premier émetteur de champ magnétique est sélectionné dans la plage [0 degré, 90 degrés], de sorte que la sensibilité du dispositif de détection est maximale, et est de préférence compris dans la plage [15 degrés, 25 degrés].

7. Dispositif de détection basé sur une magnétorésistance/une résistance à effet Hall planaire, AMR/PHR, hybride magnétique selon l'une quelconque des revendications 1 à 6, dans lequel la précision de l'alignement de l'axe avant sa rotation est inférieure à 10 nm, et la précision de l'angle de décalage α est inférieure à 1,0 degré, de préférence inférieure à 0,02 degré.

8. Dispositif de détection basé sur une magnétorésistance/une résistance à effet Hall planaire, AMR/PHR, hybride magnétique selon l'une quelconque des revendications 1 à 7, dans lequel :
le récepteur de champ magnétique (4) et le premier émetteur de champ magnétique (6) sont identiques ; ou
le récepteur de champ magnétique (4) et le premier émetteur de champ magnétique (6) diffèrent mutuellement par la forme de leur piste électromagnétique (10, 40), et/ou par le matériau de leur piste électromagnétique (10, 40).

9. Dispositif de détection basé sur une magnétorésistance/une résistance à effet Hall planaire, AMR/PHR, hybride magnétique selon l'une quelconque des revendications 1 à 8, comprenant en outre :
- un second émetteur de champ magnétique (406), en tant que troisième composant, configuré pour être excité par un courant de polarisation alimenté en courant continu et/ou en courant alternatif ou par un champ magnétique externe à mesurer, et qui inclut :
• une troisième piste magnétorésistive ou faiblement résistive (440) présentant une forme de boucle fermée ou une forme de jonction transversale ;
• une troisième paire (442) de bornes de courant formée avec une cinquième borne de courant (444) et une sixième borne de courant (446), qui se font mutuellement face, en contact avec la troisième piste (440) et formant un troisième axe aisé (448) ;
• une troisième paire (452) de bornes de tension formée avec une cinquième borne de tension (454) et une sixième borne de tension (456), qui se font mutuellement face, en contact avec la troisième piste (440) et formant un troisième axe difficile (458), orthogonal au troisième axe aisé (448) ; et
dans lequel
le premier émetteur de champ magnétique (6) et le second émetteur de champ magnétique (406) sont identiques ; et
le premier émetteur de champ magnétique (6), le récepteur de champ magnétique (4) et le second émetteur de champ magnétique (406) sont superposés et mutuellement fixés à travers le premier élément d'espacement (62) et un deuxième élément d'espacement (462), de sorte que le récepteur de champ magnétique (4) est pris en sandwich entre le premier émetteur de champ magnétique (6) et le second émetteur de champ magnétique (406).

10. Dispositif de détection basé sur une magnétorésistance/une résistance à effet Hall planaire, AMR/PHR, hybride magnétique selon la revendication 9, dans lequel
le deuxième élément d'espacement isolant (462) est configuré pour fixer le second émetteur de champ magnétique (406) au récepteur de champ magnétique (4) sur le côté opposé du premier élément d'espacement isolant (62), dès lors qu'est obtenu un alignement respectif du premier axe aisé (18) et du premier axe difficile (28) avec respectivement le troisième axe aisé (448) et le troisième axe difficile (458), suivi d'une rotation dudit troisième axe par rapport audit premier axe selon l'angle de décalage fixe prédéterminé a, et à maintenir cet agencement d'axes ainsi qu'une distance de séparation fixe e₁₃ entre la première piste (10) et la troisième piste (440) égale à la distance de séparation fixe e₁₂ entre la première piste (10) et la deuxième piste (40) ; et
le deuxième élément d'espacement (462) est une couche homogène volumineuse constituée du matériau isolant rigide en tant que matériau isolant du premier élément d'espacement (62).

11. Dispositif de détection basé sur une magnétorésistance/une résistance à effet Hall planaire, AMR/PHR, hybride magnétique selon l'une quelconque des revendications 1 à 10, comprenant en outre :
soit une unique source de courant de deuxième piste (324) pour fournir un courant continu et/ou un courant alternatif à la deuxième piste (40) du premier émetteur de champ magnétique (6) lorsque le dispositif de détection magnétique comprend le récepteur de champ magnétique et le premier émetteur de champ magnétique en tant qu'un unique émetteur de champ magnétique ;
soit une source de courant de deuxième piste (524) et une source de courant de troisième piste (526) pour fournir un courant continu et/ou un courant alternatif, respectivement, à la deuxième piste (40) du premier émetteur de champ magnétique (6) et à la troisième piste (440) du second émetteur de champ magnétique (406), lorsque le dispositif de détection magnétique comprend le récepteur de champ magnétique et deux premiers et seconds émetteurs de champ magnétique en vue de fonctionner en mode différentiel, la source de courant de deuxième piste et la source de courant de troisième piste étant configurées et reliées à la deuxième piste du premier émetteur de champ magnétique et à la troisième piste du second émetteur de champ magnétique afin de générer deux champs magnétiques, symétriques au plan du récepteur de champ magnétique et polarisés en sens inverse.

12. Dispositif de détection basé sur une magnétorésistance/une résistance à effet Hall planaire, AMR/PHR, hybride magnétique selon l'une quelconque des revendications 1 à 11, comprenant en outre un circuit amplificateur connecté aux première et deuxième bornes de tension en vue d'amplifier un signal de mesure et/ou d'annuler une tension de décalage par rapport audit signal de mesure.

13. Procédé de mesure magnétique pour mesurer une amplitude locale et/ou une variation d'un champ magnétique généré à distance ou à proximité par une ou plusieurs sources magnétiques,
le procédé de mesure magnétique comprenant les étapes ci-dessous consistant à :
- fournir (304) un dispositif de détection basé sur une magnétorésistance/une résistance à effet Hall planaire, AMR/PHR, hybride magnétique (2), comprenant un récepteur de champ magnétique (4) et un premier émetteur de champ magnétique (6) selon l'une quelconque des revendications 1 à 8 ;
- mesurer (306) une tension différentielle V_{MR} entre les bornes de tension de la première paire en utilisant un dispositif de mesure de tension connecté entre les première et deuxième bornes de tension, tout en maintenant déconnectées la première paire de bornes de courant du récepteur de champ magnétique, la première paire de bornes de tension du récepteur de champ magnétique, et la deuxième paire de bornes de courant du premier émetteur de champ magnétique, de sorte que l'impédance entre les bornes de la première paire de bornes de courant, l'impédance entre les bornes de la première paire de bornes de tension et l'impédance entre les bornes de la deuxième paire de bornes de courant sont représentatives d'un circuit ouvert ;
- déterminer (308) une amplitude locale et/ou une variation d'un champ magnétique instationnaire généré à distance ou à proximité par une ou plusieurs sources magnétiques sur la base de la tension différentielle mesurée.

14. Procédé de mesure magnétique pour mesurer une amplitude locale et/ou une variation d'un champ magnétique généré à proximité par une ou plusieurs sources magnétiques,
le procédé de mesure magnétique comprenant les étapes ci-dessous consistant à :
- fournir (354) un dispositif de détection basé sur une magnétorésistance/une résistance à effet Hall planaire, AMR/PHR, hybride magnétique comprenant un récepteur de champ magnétique et un premier émetteur de champ magnétique selon l'une quelconque des revendications 1 à 8 ;
- injecter (356) un courant continu et/ou un courant alternatif de polarisation dans la deuxième piste magnétique du premier émetteur de champ magnétique, en utilisant une source de courant de polarisation électrique connectée entre les troisième et quatrième bornes de courant du premier émetteur de champ magnétique ; et
- conduire (358) un ensemble d'une ou plusieurs particules magnétiques sensibles à un champ magnétique à proximité de ou en contact avec une zone active, du récepteur de champ magnétique, située sous la piste magnétique du premier émetteur de champ magnétique ; et ensuite
- mesurer (360) une tension différentielle V_{MR} entre les première et deuxième bornes de tension du récepteur de champ magnétique, en utilisant un dispositif de mesure de tension connecté entre les première et deuxième bornes de tension, tout en maintenant déconnectées la première paire de bornes de courant du récepteur de champ magnétique et la deuxième paire de bornes de tension du premier émetteur de champ magnétique, de sorte que l'impédance entre les bornes de la première paire de bornes de courant et l'impédance entre les bornes de la deuxième paire de bornes de tension sont représentatives d'un circuit ouvert ;
- déterminer (362) une amplitude locale et/ou une variation d'un champ magnétique instationnaire généré à proximité par les particules magnétiques sur la base de la tension différentielle mesurée.

15. Procédé de mesure magnétique pour mesurer une amplitude locale et/ou une variation d'un champ magnétique généré à proximité par une ou plusieurs sources magnétiques,
le procédé de mesure magnétique comprenant les étapes ci-dessous consistant à :
- fournir (584) un dispositif de détection basé sur une magnétorésistance/une résistance à effet Hall planaire, AMR/PHR, hybride magnétique, comprenant un récepteur de champ magnétique, un premier émetteur de champ magnétique et un second émetteur de champ magnétique selon l'une quelconque des revendications 9 à 10 ;
- injecter (586) un courant continu et/ou un courant alternatif de polarisation dans la deuxième piste magnétique du premier émetteur de champ magnétique et dans la troisième piste magnétique du second émetteur de champ magnétique, en utilisant une source de courant de polarisation électrique connectée entre les troisième et quatrième bornes de courant du premier émetteur de champ magnétique et entre les cinquième et sixième bornes de courant du second émetteur de champ magnétique, de sorte que les champs magnétiques d'excitation générés par le premier émetteur de champ magnétique et le second émetteur de champ magnétique sont polarisés en sens inverse ; et
- conduire (588) un ensemble d'une ou plusieurs particules magnétiques sensibles à un champ magnétique à proximité de ou en contact avec une zone active, du récepteur de champs magnétique, située sous la piste magnétique du premier émetteur de champ magnétique ; et ensuite
- mesurer (590) une tension différentielle V_{MR} entre les première et deuxième bornes de tension du récepteur de champ magnétique, en utilisant un dispositif de mesure de tension connecté entre les première et deuxième bornes de tension, tout en maintenant déconnectées la première paire de bornes de courant du récepteur de champ magnétique et la deuxième paire de bornes de tension du premier émetteur de champ magnétique, de sorte que l'impédance entre les bornes de la première paire de bornes de courant et l'impédance entre les bornes de la deuxième paire de bornes de tension sont représentatives d'un circuit ouvert ;
- déterminer (592) une amplitude locale et/ou une variation d'un champ magnétique instationnaire généré à proximité par les particules magnétiques, sur la base de la tension différentielle mesurée.
